(19) Europäisches Patentamt
European Patent Office
Office européen des brevets

(11) EP 4 026 036 B1

(12) **EUROPÄISCHE PATENTSCHRIFT**

(45) Veröffentlichungstag und Bekanntmachung des Hinweises auf die Patenterteilung:
**17.01.2024 Patentblatt 2024/03**

(21) Anmeldenummer: **19774068.1**

(22) Anmeldetag: **05.09.2019**

(51) Internationale Patentklassifikation (IPC):
***G06F 30/13*** *(2020.01)* ***E04D 13/04*** *(2006.01)*
***E04D 13/16*** *(2006.01)*

(52) Gemeinsame Patentklassifikation (CPC):
**G06F 30/13; E04D 13/0481; E04D 13/1693**

(86) Internationale Anmeldenummer:
**PCT/EP2019/073778**

(87) Internationale Veröffentlichungsnummer:
**WO 2021/043415 (11.03.2021 Gazette 2021/10)**

(54) **VERFAHREN ZUR ERSTELLUNG EINER STRUKTUR EINER TOPOLOGIE EINER DEFINIERT BEGRENZTEN FLÄCHE ZU DEREN ENTWÄSSERUNG**

METHOD FOR ESTABLISHING A STRUCTURE OF A TOPOLOGY OF A DEFINED LIMITED AREA FOR DRAINAGE OF SAME

PROCÉDÉ POUR ÉTABLIR UNE STRUCTURE D'UNE TOPOLOGIE D'UNE SURFACE DÉLIMITÉE DE MANIÈRE DÉFINIE AUX FINS DE SON DRAINAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**13.07.2022 Patentblatt 2022/28**

(73) Patentinhaber: **UDS URBANE DATEN-SYSTEME GMBH**
**20097 Hamburg (DE)**

(72) Erfinder:
- **BÖRNCHEN, Roman**
  **22303 Hamburg (DE)**
- **ROEDER, Mitja**
  **21073 Hamburg (DE)**

(74) Vertreter: **VKK Patentanwälte PartG mbB**
**An der Alster 84**
**20099 Hamburg (DE)**

(56) Entgegenhaltungen:

| | |
|---|---|
| **WO-A1-2016/042111** | **CA-A1- 2 521 801** |
| **DE-U1-202019 103 734** | **ES-A1- 2 297 959** |
| **US-A- 4 503 644** | **US-A- 5 663 882** |
| **US-A- 6 105 324** | **US-B1- 6 415 570** |

- **Soprema: "PIR Hochleistungs-dämmstoffe", , 1. Oktober 2017 (2017-10-01), Seiten 1-12, XP055690939, Gefunden im Internet: URL:https://www.soprema.de/fileadmin/user_ upload/40_Broschüren/Dämmstoffe/EFYOS_PIR _ Imagebroschüre.pdf [gefunden am 2020-04-30]**
- **Soprema: "EFYOS COMPACT VERLEGEANLEITUNG PIR KOMPAKTDACH, Soprema Polyurethan-Dämmsysteme", , 1. Oktober 2017 (2017-10-01), Seiten 1-4, XP055690948, Gefunden im Internet: URL:https://www.soprema.de/fileadmin/user_ upload/40_Broschüren/Dämmstoffe/EFYOS_co mp act_Verlegeanleitung.pdf [gefunden am 2020-04-30]**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 4 026 036 B1

## Beschreibung

Die vorliegende Erfindung betrifft ein Verfahren zur Erstellung einer Struktur einer Topologie einer definiert begrenzten Fläche zu deren Entwässerung über wenigstens einen vorgegebenen Entwässerungspunkt, sodass die Fläche ausgehend von dem Entwässerungspunkt bis zu einem Kollisionspunkt beispielsweise einem Dachrand und/oder einem Übergang zu einem Lichtschacht und/oder einem Übergang zu einem Fahrstuhlschacht, eine monoton steigende Neigung aufweist.

Ein derartiges Verfahren zur automatischen Belegung von Gefälledächern ist aus dem Stand der Technik bekannt. Dieses Verfahren kann zur automatischen Belegung von Gefälledächern ohne Kollisionspunkte, wie beispielsweise Innenecken eingesetzt werden. Zur Belegung von Gefälledächern mit Innenecken ist manuelle Nacharbeit erforderlich. Nachteilig an dem Verfahren aus dem Stand der Technik ist, dass damit nur Topologien für Flächen ohne Kollisionspunkte automatisch erstellt werden können. Die Erstellung von Topologien für Flächen mit beliebig vielen Kollisionspunkten ist zeitaufwändig, komplex und fehleranfällig. Ein auf einem Datenträger gespeicherter Belegungsplan ist aus dem Stand der Technik bekannt. Dieser Belegungsplan kann jedoch nur durch manuelle Nacharbeit und somit nicht komplett automatisiert erstellt werden. Nachteilig daran ist, dass die manuelle Nacharbeit fehleranfällig und zeitaufwändig ist.

US 5 663 882 A, CA 2 521 801 A1 und ES 2 297 959 A1 offenbaren bekannte Dachtopologien.

Vor diesem Hintergrund liegt der Erfindung die Aufgabe zugrunde, ein Verfahren der eingangs Art anzugeben, welches unter Umgehung der Nachteile des Standes der Technik eine effizientere, einfache und weniger fehleranfällige Festlegung einer Topologie einer definiert begrenzten Fläche zu deren Entwässerung über wenigstens einen vorgegebenen Entwässerungspunkt, sodass die Fläche ausgehend von dem Entwässerungspunkt bis zu einem Kollisionspunkt eine monoton steigende Neigung aufweist, ermöglicht.

Erfindungsgemäß wird diese Aufgabe mit einem Verfahren nach Anspruch 1 gelöst, bei welchem für jedes Flächenelement ausgehend von dem Entwässerungspunkt sukzessive in jeder Ebene eine Neigung in eine erste und/oder eine zur ersten Richtung senkrecht ausgerichteten zweiten Richtung festgelegt wird. Auf diese Weise kann erfindungsgemäß eine Topologie für eine Fläche mit beliebig vielen Kollisionspunkten wie beispielsweise Innenecken automatisch erstellt werden. Dies eröffnet verbesserte Möglichkeiten hinsichtlich der Einsparung von Material gleichermaßen wie der sicheren Entwässerung jedes Punktes der Fläche.

Nach der Erfindung umfasst das Verfahren einen Schritt, in dem für mindestens ein, vorzugsweise für jedes, direkt an den Entwässerungspunkt angrenzendes Flächenelement eine Kehlneigung festgelegt wird, indem für das Flächenelement mindestens zwei, vorzugsweise zwei, Ebenen festgelegt werden, wobei die Flächennormalen mindestens zweier Ebenen sich kreuzen und/oder in einer ersten und/oder einer zur ersten Richtung senkrecht ausgerichteten zweiten Richtung geneigt sind. Die so auf den Flächenelementen ausgebildeten Neigungen dienen der sicheren Entwässerung jedes Punktes auf der Fläche in den Entwässerungspunkt. Vorzugsweise liegt der Entwässerungspunkt auf einem Schnittpunkt der gedachten Linien, welche die Fläche in einzelnen Flächenelemente unterteilen. Somit kann für alle vier in diagonaler Richtung angrenzenden Flächenelemente unter minimalem Materialeinsatz und mit minimalem Materialverschnitt eine Kehlneigung festgelegt werden.

In einer bevorzugten Ausgestaltung der Erfindung umfasst das Verfahren einen Schritt, in dem die mindestens zwei, vorzugsweise zwei, Ebenen eines Flächenelementes mit einer Kehlneigung eine Vertiefung in diagonaler Richtung entlang des Flächenelementes ausbilden. Die so auf dem Flächenelement ausgebildete Rinne entlang einer Diagonalen eröffnet die Möglichkeit, über die Fläche einen kontinuierlichen Entwässerungspfad über die Fläche anzugeben, in dem Wasser zum Entwässerungspunkt geführt wird. Innerhalb des Entwässerungspfades entstehen durch Angleichung der Höhen der einzelnen Flächenelemente nach dem erfindungsgemäßen Verfahren flache Übergänge, ohne Stufen, an denen es zu einer Stauung des Wassers kommen könnte.

In einer vorteilhaften Ausgestaltung der Erfindung umfasst das Verfahren einen Schritt, in dem die Neigung der mindestens zwei, vorzugsweise zwei, Ebenen eines Flächenelementes in Abhängigkeit der Neigung der mindestens zwei, vorzugsweise zwei, Ebenen der in diagonaler und/oder in einer ersten und/oder einer zur ersten Richtung senkrecht ausgerichteten zweiten Richtung angrenzenden Flächenelemente in Betrag und/oder Richtung festgelegt wird. Somit wird für jedes der Flächenelemente eine optimale Neigung der Ebenen zueinander und in Richtung des Entwässerungspunktes festgelegt. Damit wird ein Verfahren zur automatischen Belegung einer Fläche mit einem Gefälle und beliebig vielen Kollisionspunkten angegeben, welches mit einem geringen Aufwand in Programme, wie beispielsweise AutoCAD integrierbar ist. Vorzugsweise ist das erfindungsgemäße Verfahren ein computerimplementiertes Verfahren. Außerdem werden diverse Informationen über den Verlauf der Neigung der Fläche und damit verbunden die Entwässerungssituation und die Kollisionspunkte gesammelt, die für die optimale Belegung genutzt werden können.

In einer bevorzugten Ausgestaltung der Erfindung umfasst das Verfahren einen Schritt, in dem für ein Flächenelement, welches in diagonaler Richtung direkt an ein Flächenelement mit Kehlneigung angrenzt, eine Kehlneigung festgelegt wird. Somit wird das Wasser durch die monoton fallende Neigung in Richtung des Entwässerungspunktes von jedem Punkt der Fläche aus zu einem Entwässerungspunkt geleitet, ohne dass an einem Punkt eine Stauung durch

einen Anstieg der Neigung erzeugt wird.

In einer vorteilhaften Ausgestaltung der Erfindung umfasst das Verfahren einen Schritt, in dem für ein Flächenelement welches, in einer ersten und/oder einer zur ersten Richtung senkrecht ausgerichteten zweiten Richtung an ein Flächenelement mit einer Kehlneigung angrenzt, eine Gefälleneigung festgelegt wird, indem eine Neigung einer Ebene des Flächenelementes in eine erste und/oder eine zur ersten Richtung senkrecht ausgerichteten zweiten Richtung monoton steigend und/oder fallend ist. Dies eröffnet die Möglichkeit der sicheren Entwässerung von Flächenelementen mit einer Ebene in Richtung des kontinuierlichen Entwässerungspfades über die Fläche, sodass an keinem Punkt der Fläche Vertiefungen gebildet werden, an denen Wasser zurückbleibt.

In einer bevorzugten Ausgestaltung der Erfindung umfasst das Verfahren einen Schritt, in dem für ein Flächenelement, welches in einer ersten und/oder einer zur ersten Richtung senkrecht ausgerichteten zweiten Richtung an ein Flächenelement mit einer Gefälleneigung angrenzt, eine Gefälleneigung festgelegt wird. So wird für jedes einzelne Flächenelement nacheinander automatisch die für die sichere Entwässerung optimale Belegung bestimmt. Damit verbunden kann ein optimaler Einsatz der Materialen sichergestellt werden und somit eine Verringerung der Materialverschnittes erzielt werden. Dies führt zu einer Einsparung an Ressourcen und ermöglicht eine Kosteneinsparung bei der Belegung von Flächen mit einem Gefälle.

In einer vorteilhaften Ausgestaltung der Erfindung umfasst das Verfahren einen Schritt, in dem die Neigung eines Flächenelementes, welches in einer ersten und/oder einer zur ersten Richtung senkrecht ausgerichteten zweiten Richtung an ein Flächenelement mit einer Gefälleneigung angrenzt, wobei das Flächenelement mit der Gefälleneigung in einer ersten und/oder einer zur ersten Richtung senkrecht ausgerichteten zweiten Richtung wenigstens einen Kollisionspunkt aufweist, als eine Kehlneigung festgelegt wird. Dies eröffnet die Möglichkeit der automatischen Erkennung und Belegung von Flächenelementen mit einem Kollisionspunkt beispielsweise einem Dachrand und/oder einem Übergang zu einem Lichtschacht und/oder einem Übergang zu einem Fahrstuhlschacht, sodass die Entwässerung um den Kollisionspunkt herum erfolgt und Wasser auch ausgehend von diesen Punkten in Richtung des Entwässerungspunktes abgeleitet wird.

In einer bevorzugten Ausgestaltung der Erfindung umfasst das Verfahren einen Schritt, in dem die Neigung einer Ebene eines Flächenelementes mit einer Gefälleneigung in Richtung wenigstens eines Kollisionspunktes als eine um 90° gegen den Kollisionspunkt versetzte Gefälleneigung festgelegt wird. Somit wird Wasser auch an dieser Stelle um den Kollisionspunkt herum in Richtung des Entwässerungspunktes der Fläche geleitet und fließt nicht direkt auf den Kollisionspunkt zu an dem es dann zu einer Stauung des Wassers kommen kann. Dies stellt die zuverlässige Entwässerung an jedem Punkt, insbesondere an Kollisionspunkten der Fläche sicher.

In einer vorteilhaften Ausgestaltung der Erfindung umfasst das Verfahren einen Schritt, in für eine Ebene eines Flächenelementes, welches in einer ersten und/oder einer zur ersten Richtung senkrecht ausgerichteten zweiten Richtung jeweils an ein Flächenelement mit einer Gefälleneigung angrenzt, wobei die Gefälleneigungen jeweils aufeinander zu gerichtet sind, eine Flachneigung festgelegt wird, wobei die Neigung der Ebene null ist, wobei der Betrag der Neigung gleich dem Betrag der Gefälleneigung des angrenzenden Flächenelementes mit dem größeren Betrag ist. Somit entsteht über die gesamte Fläche ein Entwässerungspfad mit einer monoton fallenden Neigung in Richtung des Entwässerungspunktes und es kommt an keinem der Punkte zu einem Anstieg der Neigung, der von dem abfließenden Wasser nicht überwunden werden kann.

In einer bevorzugten Ausgestaltung der Erfindung umfasst das Verfahren einen Schritt, in dem für ein Flächenelement, welches in einer ersten und/oder einer zur ersten Richtung senkrecht ausgerichteten zweiten Richtung an ein Flächenelement mit einer Kehlneigung angrenzt und das in diagonaler Richtung an ein Flächenelement mit einer Gefälleneigung angrenzt, eine Gratneigung festgelegt wird, wobei die mindestens zwei, vorzugsweise zwei, Ebenen des Flächenelementes sich schneiden und/oder in einer ersten und/oder einer zur ersten Richtung senkrecht ausgerichteten zweiten Richtung in entgegengesetzter Richtung der Neigung der Flächennormalen des Flächenelementes mit der Kehlneigung geneigt sind. Dies ermöglicht die automatische Belegung einer Fläche mit einem Gefälle zur sicheren Entwässerung bei einer optimalen Bestimmung der Anzahl der verwendeten Platten, welche auf der Fläche verlegt werden.

In einer vorteilhaften Ausgestaltung der Erfindung umfasst das Verfahren einen Schritt, in dem für ein Flächenelement, welches in einer ersten und/oder einer zur ersten Richtung senkrecht ausgerichteten zweiten Richtung an ein Flächenelement mit einer Kehlneigung angrenzt, das in diagonaler Richtung an ein Flächenelement mit eine Gefälleneigung angrenzt eine Gratneigung festgelegt wird, wobei die Flächennormalen der mindestens zwei, vorzugsweise zwei, Ebenen des Flächenelementes sich schneiden und/oder in einer ersten und/oder einer zur ersten Richtung senkrecht ausgerichteten zweiten Richtung in entgegengesetzter Richtung der Neigung der Flächennormalen des Flächenelementes mit der Kehlneigung geneigt sind. Dies ermöglicht eine automatische Belegung der Flächenelemente, sodass Wasser über die geneigten Ebenen eines Flächenelementes mit einer Erhöhung zu beiden Seiten der Erhöhung jeweils in Richtung des Entwässerungspunkt geleitet wird und somit ein Entwässerungspfad mit einer monoton fallenden Neigung in Richtung des Entwässerungspunktes angegeben wird.

In einer bevorzugten Ausgestaltung der Erfindung umfasst das Verfahren einen Schritt, in dem festgelegt wird,

dass die mindestens zwei, vorzugsweise zwei, Ebenen eines Flächenelementes mit einer Gratneigung eine Erhöhung in diagonaler Richtung entlang des Flächenelementes ausbilden. Somit kommt es an keinem Übergang zwischen zwei Flächenelementen unterschiedlicher Höhe zu einem Übergang, der zu einer Stauung des Wassers führen kann.

In einer vorteilhaften Ausgestaltung der Erfindung umfasst das Verfahren einen Schritt, in dem für ein Flächenelement, in dem zwei Gefälleneigungen in unterschiedliche Richtung senkrecht aufeinander stehen, eine Gratneigung festgelegt wird. Dies eröffnet die Möglichkeit, dass die Ausbildung von Senken, in denen sich Wasser sammelt und nicht zum Entwässerungspunkt abgeleitet wird, innerhalb der Fläche verhindert wird, sodass eine sichere Entwässerung der Fläche gewährleistet ist. Außerdem kann der Materialeinsatz optimiert werden, indem der Materialverschnitt verringert wird.

In einer bevorzugten Ausgestaltung der Erfindung umfasst das Verfahren einen Schritt, in dem für ein Flächenelement, welches in einer ersten und/oder einer zur ersten Richtung senkrecht ausgerichteten zweiten Richtung und/oder in einer diagonalen Richtung direkt an wenigstens zwei, vorzugsweise zwei in einer ersten und/oder einer zur ersten Richtung senkrecht ausgerichteten zweiten Richtung direkt aneinander angrenzende Flächenelemente mit einer Kehlneigung angrenzt, wobei die Kehlneigung jeweils monoton steigend in Richtung eines Punktes ist, eine Gefälleneigung festgelegt wird, wobei die Flächennormale des Flächenelementes parallel zu den Flächennormalen des Flächenelementes mit der Kehlneigung ist. Somit wird mittels der automatischen Belegung Wasser ausgehend von einem Sammelpunkt in einen monoton fallenden Entwässerungspfad und somit auf dem kürzesten Weg zum Entwässerungspunkt der Fläche geleitet.

In einer vorteilhaften Ausgestaltung der Erfindung umfasst das Verfahren einen Schritt, für ein Flächenelement, welches in der ersten und/oder der zur ersten Richtung senkrecht ausgerichteten zweiten Richtung zwischen zwei Flächenelementen mit jeweils einer Kehlneigung liegt, wobei die Kehlneigung jeweils monoton steigend in Richtung eines Punktes ist, eine Flachneigung festgelegt wird, wobei der Betrag der Neigung als der Betrag der Neigung des angrenzenden Flächenelementes mit dem größeren Betrag festgelegt wird. Somit kommt es an keinem Übergang zwischen zwei Flächenelementen unterschiedlicher Höhe zu einem Übergang, der zu einer Stauung des Wassers führen kann.

In einer bevorzugten Ausgestaltung der Erfindung umfasst das Verfahren einen Schritt, in dem für ein Flächenelement, welches in diagonaler Richtung an ein Flächenelement mit einer Kehlneigung und/oder in einer ersten und/oder einer zur ersten Richtung senkrecht ausgerichteten zweiten Richtung an ein Flächenelement mit einer Flachneigung angrenzt eine Gefälleneigung festgelegt wird, wobei die Flächennormale des Flächenelementes in die gleiche Richtung wie Flächennormalen der Flächenelemente mit der Kehlneigung geneigt ist. Dies stellt eine optimale Entwässerung an jedem Punkt der Fläche sicher, indem Wasser auf dem kürzesten Weg zum nächstgelegenen Entwässerungspunkt der Fläche entlang eines kontinuierlichen Entwässerungspfades geleitet wird.

In einer vorteilhaften Ausgestaltung der Erfindung umfasst das Verfahren einen Schritt, in dem für ein Flächenelement, welches in einer ersten und/oder einer zur ersten Richtung senkrecht ausgerichteten zweiten Richtung an jeweils ein Flächenelement mit einer Kehlneigung angrenzt, wobei sich die Flächennormalen der Flächenelemente mit der Kehlneigung kreuzen, jeweils eine Gratneigung festgelegt wird. Dies dient der automatischen und korrekten Belegung der Flächenelemente mit einer definierten Neigung zur optimalen Entwässerung einer Fläche mit einem Gefälle.

In einer bevorzugten Ausgestaltung der Erfindung umfasst das Verfahren einen Schritt, in dem für ein Flächenelement, welches in einer ersten und/oder einer zur ersten Richtung senkrecht ausgerichteten zweiten Richtung direkt an wenigstens drei, vorzugsweise drei Flächenelemente mit einer Kehlneigung angrenzt, wobei sich die Flächennormalen der Flächenelemente mit der Kehlneigung kreuzen, eine Gratneigung festgelegt wird, wobei die Flächennormale des Flächenelementes mit der Gratneigung nicht die Flächennormalen der Flächenelemente mit Kehlneigung kreuzt. Somit entsteht über die gesamte Fläche ein Entwässerungspfad mit einer monoton fallenden Neigung in Richtung des Entwässerungspunktes und es kommt an keinem der Punkte zu einem Anstieg der Neigung, der von dem abfließenden Wasser nicht überwunden werden kann. Damit kann die gesamte Fläche automatisch belegt werden und das eingesetzte Material kann optimal ausgenutzt werden, was zu einer Einsparung hinsichtlich der eingesetzten Ressourcen führt.

In einer vorteilhaften Ausgestaltung der Erfindung umfasst das Verfahren einen Schritt, in dem für ein Flächenelement, welches in einer diagonalen Richtung an ein Flächenelement mit einer Kehlneigung angrenzt, wobei das Flächenelement mit der Kehlneigung in einer ersten und/oder einer zur ersten Richtung senkrecht ausgerichteten zweiten Richtung wenigstens einen Kollisionspunkt aufweist, eine Gefälleneigung festgelegt wird, wobei die Kehlneigung monoton steigend in Richtung des Kollisionspunktes und die Gefälleneigung monoton steigend oder fallend entlang des Kollisionspunktes ist. Dies eröffnet die Möglichkeit der automatischen Erkennung und Belegung von Flächenelementen mit einem Kollisionspunkt beispielsweise einem Dachrand und/oder einem Übergang zu einem Lichtschacht und/oder einem Übergang zu einem Fahrstuhlschacht, sodass die Entwässerung um den Kollisionspunkt herum erfolgt und Wasser auch ausgehend von diesen Punkten in Richtung des Entwässerungspunktes abgeleitet wird. Somit wird Wasser auch an dieser Stelle um den Kollisionspunkt herum in Richtung des Entwässerungspunktes der Fläche geleitet und fließt nicht direkt auf den Kollisionspunkt zu an dem es dann zu einer Stauung des Wassers kommen kann. Dies stellt die zuverlässige Entwässerung an jedem Punkt, insbesondere an Kollisionspunkten der Fläche sicher.

In einer bevorzugten Ausgestaltung der Erfindung ist die Fläche eine Dachfläche. Dies eröffnet die Möglichkeit Dachflächen mit einem Gefälle und beliebig vielen Kollisionspunkten, die beispielsweise Innenecken oder Dachränder sein können automatisch zu belegen und somit eine optimale Entwässerung zu gewährleisten.

Gemäß der Erfindung ist durch das beanspruchte Verfahren ein auf einem Datenträger gespeicherter Belegungsplan für eine Fläche zur Darstellung für einzelne Flächenelemente festgelegter Neigungen, als Anleitung zur Erstellung einer Struktur einer Topologie zum Entwässern einer definiert begrenzten Fläche, entsprechend den festgelegten Neigungen, wobei die Platten der Abmessungen und/oder der geometrischen Form der einzelnen Flächenelemente entsprechen, erhältlich. Somit liegt eine genaue Beschreibung vor, die alle Informationen bezüglich der Topologie der Fläche für eine Auswahl der zur Belegung notwendigen Platten, enthält. Weiterhin stellt der Belegungsplan die Anordnung der Platten zueinander detailliert dar, sodass dieser als Anleitung verwendet werden kann.

Die Aufgabe des Aufbaus der Struktur einer Topologie zum Entwässern einer definiert begrenzten Fläche, insbesondere Dach und/oder Parkdeck, wird gelöst, indem sie aus einzelnen Platten aufgebaut ist, deren Abmessung und/oder geometrische Form einzelnen Flächenelementen gemäß einem Belegungsplan angepasst ist. Durch eine derartige Struktur der Topologie ist sichergestellt, dass an jedem Punkt der Fläche auftreffendes Wasser kontrolliert in Richtung eines Entwässerungspunktes abfließen kann und es nicht zu einer Stauung kommt.

In einer vorteilhaften Ausgestaltung des Verfahrens gemäß der Erfindung sind die Verfahrensschritte zur Festlegung der Topologie zur Implementierung in eine Software ausgebildet, wobei wenigstens ein Entwässerungspunkt und/oder ein Grundriss als Eingabewert festgelegt ist. Somit kann vom Anwender der Entwässerungspunkt innerhalb des Grundrisses angegeben werden und davon ausgehend die optimale Belegung der entsprechenden Fläche simuliert werden.

Die Erfindung wird in einer bevorzugten Ausführungsform unter Bezugnahme auf eine Zeichnung beispielhaft beschrieben, wobei weitere vorteilhafte Einzelheiten den Figuren der Zeichnung zu entnehmen sind. Funktionsmäßig gleiche Teile sind dabei mit denselben Bezugszeichen versehen.

Die Figuren der Zeichnung zeigen im Einzelnen:

Figur 1: In einer Draufsicht eine schematische Darstellung einer geneigten Fläche, gemäß dem erfindungsgemäßen Verfahren in einzelne Flächenelemente unterteilt;

Figur 2: in einer Seitenansicht eine schematische Darstellung eines Flächenelementes mit einer Ebene, wobei die Ebene eine Gefälleneigung aufweist;

Figur 3: in einer Seitenansicht eine schematische Darstellung eines Flächenelementes mit einer Ebene, wobei die Ebene eine Flachneigung aufweist;

Figur 4: in einer Seitenansicht eine schematische Darstellung eines Flächenelementes mit zwei Ebenen, wobei die Ebenen eine Kehlneigung aufweisen;

Figur 5: in einer Seitenansicht eine schematische Darstellung eines Flächenelementes mit mindestens zwei, vorzugsweise zwei, Ebenen, wobei die Ebenen eine Gratneigung aufweisen;

Figur 6: in einer Draufsicht eine schematische Darstellung einer möglichen Ausgangssituation zweier aneinander angrenzender Flächenelemente, anhand derer eine Neigung für das in x-Richtung angrenzende, unbelegte Flächenelemente festgelegt wird und die daraus resultierende Endzustand nachdem die Neigung für alle unbelegten Flächenelemente festgelegt wurde;

Figur 7: in einer Draufsicht eine schematische Darstellung einer möglichen Ausgangssituation von vier aneinander angrenzenden Flächenelementen, anhand derer eine Neigung für die in x- und y- und diagonaler Richtung angrenzenden, unbelegten Flächenelemente festgelegt wird und die daraus resultierende Endzustand nachdem die Neigung für alle unbelegten Flächenelemente festgelegt wurde;

Figur 8: in einer Draufsicht eine schematische Darstellung einer möglichen Ausgangssituation von vier aneinander angrenzende Flächenelementen, anhand derer eine Neigung für die in x- und y- Richtung angrenzenden, unbelegten Flächenelemente festgelegt wird, wobei zwischen den einzelnen Flächenelementen ein Kollisionspunkt liegt, einen zur Festlegung der endgültigen Neigung erforderlichen Zwischenschritt und die daraus resultierende Endzustand nachdem die Neigung für alle unbelegten Flächenelemente festgelegt wurde;

Figur 9: in einer Draufsicht eine schematische Darstellung einer möglichen Ausgangssituation von vier aneinander

angrenzenden Flächenelementen, anhand derer eine Neigung für das in x- und y- und diagonaler Richtung angrenzende, unbelegte Flächenelement festgelegt wird, drei zur Festlegung der endgültigen Neigung erforderliche Zwischenschritte und die daraus resultierende Endzustand nachdem die Neigung für das unbelegte Flächenelement festgelegt wurde;

Figur 10: in einer Draufsicht eine schematische Darstellung einer möglichen Ausgangssituation von vier aneinander angrenzenden Flächenelementen, anhand derer eine Neigung für das in x- und y- und diagonaler Richtung angrenzende, unbelegte Flächenelement festgelegt wird und die daraus resultierende Endzustand nachdem die Neigung für das unbelegte Flächenelement festgelegt wurde;

Figur 11: in einer Draufsicht eine schematische Darstellung einer möglichen Ausgangssituation dreier aneinander angrenzender Flächenelemente, anhand derer eine Neigung für das in x-Richtung angrenzende, unbelegte Flächenelemente festgelegt wird, einen zur Festlegung der endgültigen Neigung erforderlichen Zwischenschritt und die daraus resultierende Endzustand nachdem die Neigung für alle das unbelegte Flächenelement festgelegt wurde;

Figur 12: in einer Draufsicht eine schematische Darstellung einer möglichen Ausgangssituation von vier aneinander angrenzenden Flächenelementen, anhand derer eine Neigung für die in x- und y- und diagonaler Richtung angrenzenden, unbelegten Flächenelemente festgelegt wird und die daraus resultierende Endzustand nachdem die Neigung für die unbelegten Flächenelemente festgelegt wurde;

Figur 13: in einer Draufsicht eine schematische Darstellung einer möglichen Ausgangssituation von sechs aneinander angrenzenden Flächenelementen, anhand derer eine Neigung für die in x- und y- und diagonaler Richtung angrenzenden, unbelegten Flächenelemente festgelegt wird, zwei zur Festlegung der endgültigen Neigung erforderliche Zwischenschritte und die daraus resultierende Endzustand nachdem die Neigung für die unbelegten Flächenelemente festgelegt wurde;

Figur 14: in einer Draufsicht eine schematische Darstellung einer möglichen Ausgangssituation von vier aneinander angrenzenden Flächenelementen, anhand derer eine Neigung für die in x- und y- und diagonaler Richtung angrenzenden, unbelegten Flächenelemente festgelegt wird und die daraus resultierende Endzustand nachdem die Neigung für die unbelegten Flächenelemente festgelegt wurde;

Figur 15: in einer Draufsicht eine schematische Darstellung einer möglichen Ausgangssituation von vier aneinander angrenzenden Flächenelementen, anhand derer eine Neigung für das in x- und y- und diagonaler Richtung angrenzende, unbelegte Flächenelement festgelegt wird und die daraus resultierende Endzustand nachdem die Neigung für das unbelegte Flächenelemente festgelegt wurde

Figur 16: in einer Draufsicht eine schematische Darstellung einer möglichen Ausgangssituation von vier aneinander angrenzende Flächenelementen, anhand derer eine Neigung für die in x- und y- Richtung angrenzenden, unbelegten Flächenelemente festgelegt wird, wobei zwischen den einzelnen Flächenelementen ein Kollisionspunkt liegt, einen zur Festlegung der endgültigen Neigung erforderlichen Zwischenschritt und die daraus resultierende Endzustand nachdem die Neigung für alle unbelegten Flächenelemente festgelegt wurde

Figur 17: in einer Draufsicht eine schematische Darstellung der sukzessiven Festlegung der Neigungen der einzelnen Flächenelemente, ausgehend von Entwässerungspunkten innerhalb eines Grundrisses einer Fläche, in fünf ausgewählten aufeinanderfolgenden Verfahrensschritten.

Die Figur 1 zeigt eine Fläche 1 mit einem Gefälle, die gemäß dem erfindungsgemäßen Verfahren in einzelne Flächenelemente 2 unterteilt ist, wobei die geometrische Form der einzelnen Flächenelemente 2 die geometrische Form der Platten darstellt, mit denen die Fläche 1 zu belegen ist. Derartig Platten zur Belegung von Flächen aus unterschiedlichen Materialien und in diversen standardisierten Abmessungen können beispielsweise Dachplatten oder Fußbodenplatten mit unterschiedlichen Neigungen beispielsweise Kehlneigung, Gratneigung, Gefälleneigung oder Flachneigung sein.

Die Figur 2 zeigt in einer Seitenansicht ein Gefälleelement 6 mit einer Ebene 3 in einer Gefälleneigung. Die Neigung der Ebene wird entsprechend der Vorgabe für jede Fläche individuell oder anhand einer DIN-Norm festgelegt.

Die Figur 3 zeigt in einer Seitenansicht ein Flachelement 18 mit einer Ebene 3 in einer Flachneigung, das bedeutet, dass die Neigung der Ebene 3 gleich null ist.

Die Figur 4 zeigt in einer Seitenansicht ein Kehlelement 8 mit zwei Ebenen 3, die zueinander so ausgerichtet sind, dass sie eine Vertiefung 3a über das Flächenelement 2 ausbilden. Eine derartige Neigung der Ebenen 3 ist eine Kehlneigung.

Die Figur 5 zeigt in einer Seitenansicht ein Gratelement 17 mit zwei Ebenen 3, die zueinander so ausgerichtet sind, dass sie eine Erhöhung über das Flächenelement 2 ausbilden. Eine derartige Neigung der Ebenen 3 ist eine Gratneigung.

Die Figur 6 stellt in der linken Darstellung eine Draufsicht einer möglichen Ausgangssituation 4, vor der Durchführung des erfindungsgemäßen Verfahrens dar. In dieser Ausgangssituation 4 grenzt ein unbelegtes Flächenelement 7 in x-Richtung direkt an Gefälleelement 6. Dem unbelegten Flächenelement 7 ist keine Neigung zugeordnet. Dem Gefälleelement 6 ist eine monoton fallende Neigung in x-Richtung zugeordnet. Figur 6 zeigt in der rechten Darstellung eine Draufsicht des Endzustandes 5, nach der Durchführung des erfindungsgemäßen Verfahrens. Daraus ist ersichtlich, dass für das unbelegte Flächenelement 7 in einem Verfahrensschritt eine Gefälleneigung festgelegt wurde. Die Eigenschaften der Neigung werden mittels eines dreidimensionalen Vektors $v_a$ dargestellt. Der dreidimensionale Vektor $v_a$ umfasst einen Ortsvektor $v_a^{bp}$ und einen Richtungsvektor $v_a^{bk}$. In dem Vektor $v_a$ ist der Höhe der Neigung und die Ausrichtung der Neigung gespeichert. In dem Ortsvektor $v_a^{bp}$ ist die Höhe des jeweiligen Flächenelementes 2 gespeichert. In dem Richtungsvektor $v_a^{bk}$ die Ausrichtung der Neigung des jeweiligen Flächenelementes 2 gespeichert.

Innerhalb des Verfahrensschrittes wird die Neigung für das in x-Richtung direkt angrenzende unbelegte Flächenelement 7 in Abhängigkeit der Eigenschaften der Neigung des ursprünglichen Flächenelementes, die in dem dreidimensionalen Vektors $v_{alt}$ 9 gespeichert sind in Betrag und Richtung festgelegt und in einem dreidimensionalen Vektor $v_{neu}$ 10 gespeichert. Somit wird für das angrenzende Flächenelement eine Gefälleneigung festgelegt und in dem dreidimensionalen Vektor $v_{neu}$ gespeichert, der die folgenden Komponenten umfasst.

$$v_{neu}^{xp} = v_{alt}^{xp} + v_{alt}^{xk} \qquad v_{neu}^{yp} = v_{alt}^{yp} + v_{alt}^{yk} \qquad v_{neu}^{zp} = v_{alt}^{zp} + v_{alt}^{zk}$$
$$v_{neu}^{xk} = v_{alt}^{xk} \qquad v_{neu}^{yk} = v_{alt}^{yk} \qquad v_{neu}^{zk} = v_{alt}^{zk}$$

Der dreidimensionale Vektor $v_a$ ist stets entgegen der Wasserfließrichtung ausgerichtet.

Die Figur 7 stellt in der linken Darstellung eine Draufsicht einer möglichen Ausgangssituation 4, vor der Durchführung des erfindungsgemäßen Verfahrens dar. In dieser Ausgangssituation 4 grenzt ein Kehlelement 8 in x- und y-Richtung und in diagonaler Richtung direkt an unbelegte Flächenelement 7, für die keine Neigung festgelegt wurde. Dem Kehlelement 8 ist eine monoton fallende Neigung zugeordnet in Richtung des Entwässerungspunktes zugeordnet. Die Figur 7 zeigt in der rechten Darstellung der Endzustand 5. Daraus ist ersichtlich, dass in einem erfindungsgemäßen Verfahrensschritt die Neigungen für die jeweils angrenzenden Flächenelemente 2 festgelegt wurden. Die in x- und y-Richtung angrenzenden Flächenelemente sind Gefälleelemente 6. Das in diagonaler Richtung angrenzende Flächenelement ist ein Kehlelement 8.

Für die in x- und y-Richtung angrenzenden Flächenelemente wird eine Gefälleneigung festgelegt und in den dreidimensionalen Vektoren $v_{dx}$ 11 und $v_{dy}$ 12 mit den Komponenten

$$v_{dx}^{xp} = v_{alt}^{xp} + v_{alt}^{xk}\,;\ v_{dx}^{yp} = v_{alt}^{yp} + sgn\left(v_{alt}^{yk}\right) * \frac{g_h}{2}\,;\ v_{dx}^{zp} = v_{alt}^{zp} + v_{alt}^{zk}$$
$$v_{dx}^{xk} = v_{alt}^{xk}\,;\ v_{dx}^{yk} = 0;\ v_{dx}^{zk} = v_{alt}^{zk}$$

und

$$v_{dy}^{xp} = v_{alt}^{xp} + sgn\left(v_{alt}^{xk}\right) * \frac{g_b}{2}\,;\ v_{dy}^{yp} = v_{alt}^{yp} + v_{alt}^{yk};\ v_{dy}^{zp} = v_{alt}^{zp} + v_{alt}^{zk}$$
$$v_{dx}^{xk} = 0\,;\ v_{dy}^{yk} = v_{alt}^{yk};\ v_{dy}^{zk} = v_{alt}^{zk}$$

gespeichert.

Dabei ist $g_h$ die Länge des Flächenelementes 13 und $g_b$ die Breite des Flächenelementes 14, *sgn* ist die Signumfunktion.

Für das in diagonale Richtung angrenzende Flächenelement wir eine Kehlneigung festgelegt und in dem dreidimensionalen Vektor $v_{neu}$ 10 mit den Komponenten

$$v_{neu}^{xp} = v_{alt}^{xp} + v_{alt}^{xk} \quad v_{neu}^{yp} = v_{alt}^{yp} + v_{alt}^{yk} \quad v_{neu}^{zp} = v_{alt}^{zp} + v_{alt}^{zk}$$
$$v_{neu}^{xk} = v_{alt}^{xk} \quad v_{neu}^{yk} = v_{alt}^{yk} \quad v_{neu}^{zk} = v_{alt}^{zk}$$

gespeichert.

Die Figur 8 stellt in der linken Darstellung eine Draufsicht einer möglichen Ausgangssituation 4, vor der Durchführung des erfindungsgemäßen Verfahrens dar. In dieser Ausgangssituation 4 grenzen zwei in x-Richtung direkt aneinander angrenzende Gefälleelemente 6 in y-Richtung direkt an zwei unbelegte Flächenelemente 7, wobei sich zwischen dem Gefälleelemente 6 und dem unbelegten Flächenelement 7 ein Kollisionspunkt 16 befindet der beispielsweise ein Lichtschacht oder ein Fahrstuhlschacht ist. Die mittlere Darstellung der Figur 8 zeigt einen Zwischenschritt 15 des erfindungsgemäßen Verfahrens. In diesem Zwischenschritt 15 werden die Neigungen für die zwei in y-Richtung angrenzenden unbelegte Flächenelemente 7 festgelegt, wobei der Kollisionspunkt 16 berücksichtigt werden muss, da die Neigung so festgelegt werden muss, dass Wasser um den Kollisionspunkt 16 herumgeleitet wird. Aus der mittleren Darstellung der Figur 8 ist ersichtlich, dass das in y-Richtung an den Kollisionspunkt 16 angrenzende Flächenelement ein Kehlelement 8 ist, also eine Kehlneigung festgelegt wurde, somit wird Wasser in der Vertiefung 3a, die ein Kehlelement ausbildet um den Kollisionspunkt 16 herumgeleitet. Das in y-Richtung an das Gefälleelement 6 angrenzende Flächenelement ist ebenfalls ein Gefälleelement 6, da eine Gefälleneigung festgelegt wurde.

Die für das in y-Richtung direkt angrenzende Flächenelement festgelegte Kehlneigung wird in dem dreidimensionalen Vektor $v_{neu}$ 10 mit den Komponenten

$$v_{neu}^{xp} = v_{alt}^{xp} + \frac{g_b}{2} \quad v_{neu}^{yp} = v_{alt}^{yp} + v_{alt}^{yk} \quad v_{neu}^{zp} = v_{alt}^{zp} + v_{alt}^{zk}$$
$$v_{neu}^{xk} = -g_b \quad v_{neu}^{yk} = v_{alt}^{yk} \quad v_{neu}^{zk} = v_{alt}^{zk}$$

gespeichert.

Aus der rechten Darstellung der Figur 8, welche der Endzustand 5, nach der Durchführung eines erfindungsgemäßen Verfahrensschrittes zeigt, ist ersichtlich, dass die Neigung des an den Kollisionspunkt 16 angrenzenden Gefälleelementes 6 um 90° entgegen des Kollisionspunktes 16 gedreht ist und ist ebenfalls eine Gefälleneigung ist. Somit wird auch von diesem Gefällelement 6 Wasser um den Kollisionspunkt 16 herumgeleitet.

Je nach Lage des Kollisionspunktes 16 und der Ausrichtung der Neigung des Gefälleelementes 6 in der Ausgangssituation 4 sind insgesamt acht Fälle zu unterschieden. Ist eine Gefälleelement 6 in y-Richtung geneigt und grenzt an einen Kollisionspunkt 16 wird für die in y-Richtung an den Kollisionspunkt 16 angrenzenden Kehlelemente 8 eine Neigung festgelegt und in dem dreidimensionalen Vektor $v_{neu}$ 10 mit den Komponenten

$$v_{neu}^{xp} = v_{alt}^{xp} + v_{alt}^{xk} \quad v_{neu}^{yp} = v_{alt}^{yp} - \frac{g_h}{2} \quad v_{neu}^{zp} = v_{alt}^{zp} + v_{alt}^{zk}$$
$$v_{neu}^{xk} = v_{alt}^{xk} \quad v_{neu}^{yk} = g_h \quad v_{neu}^{zk} = v_{alt}^{zk}$$

für den 1. oder 2. Quadranten oder dem dreidimensionalen Vektor $v_{neu}$ 10 mit den Komponenten

$$v_{neu}^{xp} = v_{alt}^{xp} + v_{alt}^{xk} \quad v_{neu}^{yp} = v_{alt}^{yp} + \frac{g_h}{2} \quad v_{neu}^{zp} = v_{alt}^{zp} + v_{alt}^{zk}$$
$$v_{neu}^{xk} = v_{alt}^{xk} \quad v_{neu}^{yk} = -g_h \quad v_{neu}^{zk} = v_{alt}^{zk}$$

für den 3. oder 4. Quadranten gespeichert.

Ist eine Gefälleelement 6 in x-Richtung geneigt und grenzt an einen Kollisionspunkt 16 wird für die in x-Richtung an den Kollisionspunkt 16 angrenzenden Kehlelemente 8 eine Neigung festgelegt und in dem dreidimensionalen Vektor $v_{neu}$ 10 mit den Komponenten

$$v_{neu}^{xp} = v_{alt}^{xp} + \frac{g_b}{2} \qquad v_{neu}^{yp} = v_{alt}^{yp} + v_{alt}^{yk} \qquad v_{neu}^{zp} = v_{alt}^{zp} + v_{alt}^{zk}$$
$$v_{neu}^{xk} = -g_b \qquad v_{neu}^{yk} = v_{alt}^{yk} \qquad v_{neu}^{zk} = v_{alt}^{zk}$$

für den 1. oder 3. Quadranten oder dem dreidimensionalen Vektor $v_{neu}$ mit den Komponenten

$$v_{neu}^{xp} = v_{alt}^{xp} - \frac{g_b}{2} \qquad v_{neu}^{yp} = v_{alt}^{yp} + v_{alt}^{yk} \qquad v_{neu}^{zp} = v_{alt}^{zp} + v_{alt}^{zk}$$
$$v_{neu}^{xk} = g_b \qquad v_{neu}^{yk} = v_{alt}^{yk} \qquad v_{neu}^{zk} = v_{alt}^{zk}$$

für den 2. oder 4. Quadranten gespeichert.

Die Neigung des Gefälleelementes 6 wird in einem abschließenden Schritt jeweils um 90° entgegen des Kollisionspunktes 16 gedreht festgelegt.

Die Figur 9 stellt in der linken Darstellung eine Draufsicht einer weiteren möglichen Ausgangssituation 4, vor der Durchführung des erfindungsgemäßen Verfahrens dar. In dieser Ausgangssituation 4 grenzen in x-und y-Richtung jeweils ein Gefälleelement 6 und in diagonaler Richtung ein Gratelement 17 an ein unbelegtes Flächenelement 7. Anhand der drei mittleren Darstellung der Figur 9 ist ersichtlich, dass in dem unbelegten Flächenelement 7, nach der Durchführung der Zwischenschritte 15 theoretisch zwei Gefälleelemente 6 liegen, deren Neigung in unterschiedliche Richtung ausgerichtet ist. Die Neigung der Gefälleelemente ist jeweils in den dreidimensionalen Vektoren $v_{dx}$ 11 und $v_{dy}$ 12 gespeichert.

In der Realität wäre somit eine sichere Entwässerung des Flächenelementes nicht gewährleistet. Daher wird für das Flächenelement eine Gratneigung festgelegt. Somit wird Wasser über die beiden zueinander geneigten Ebenen des Gratelementes 17 abgeleitet. In der Endzustand 5, welche die rechte Darstellung der Figur 9 in einer Draufsicht zeigt, grenzt an die beiden Gefälleelemente 6 in x-und y-Richtung ein Gratelement mit einer Gratneigung.

Die Gratneigung wird in dem dreidimensionalen Vektor $v_{neu}$ 10 mit den Komponenten

$$v_{neu}^{xk} = v_{dx}^{xk} + v_{dy}^{xk};\ v_{neu}^{yk} = v_{dx}^{yk} + v_{dy}^{yk};\ v_{neu}^{zk} = max\{v_{dx}^{zk}, v_{dy}^{zk}\}$$

und

$$v_{neu}^{xp} = \begin{cases} v_{dy}^{xp},\ v_{dx}^{xk} = 0 \\ v_{dy}^{xp} - sgn(v_{dx}^{xk}) * \frac{g_b}{2},\ v_{dx}^{yk} = 0 \end{cases};\quad v_{neu}^{yp} = \begin{cases} v_{dy}^{yp} - sgn(v_{dx}^{yk}) * \frac{g_h}{2},\ v_{dx}^{xk} = 0 \\ v_{dy}^{yp},\ v_{dx}^{yk} = 0 \end{cases};$$

$$v_{neu}^{zp} = v_{alt}^{zp} + v_{neu}^{zk}$$

gespeichert.

In diesem Gefälleadditionsschritt werden die beiden dreidimensionalen Vektoren $v_{dx}$ 11 und $v_{dy}$ 12 addiert und somit der dreidimensionale Vektor $v_{neu}$ 10 erzeugt.

Die Figur 10 stellt in der linken Darstellung eine Draufsicht einer weiteren möglichen Ausgangssituation 4, vor der Durchführung des erfindungsgemäßen Verfahrens dar. In dieser Ausgangssituation 4 grenzt das unbelegte Flächenelement 7 in x-Richtung an ein Gefälleelement 6, wobei die Neigung monoton steigend in Richtung des unbelegten Flächenelementes 7 ist. In y-Richtung grenzt das unbelegte Flächenelement 7 an ein Kehlelement 8. Die rechte Darstellung der Figur 10 zeigt der Endzustand 5 nach der Durchführung des erfindungsgemäßen Verfahrens, daraus ist ersichtlich, dass für das unbelegte Flächenelement 7 ein Gratelement 17 ist, nachdem eine Gratneigung festgelegt wurde. Die Gratneigung wird in dem dreidimensionalen Vektor $v_{neu}$ mit den Komponenten

$$v_{neu}^{xp} = v_{alt}^{xp} + v_{alt}^{xk} \qquad v_{neu}^{yp} = v_{alt}^{yp} + v_{alt}^{yk} \qquad v_{neu}^{zp} = v_{alt}^{zp} + v_{alt}^{zk}$$
$$v_{neu}^{xk} = v_{alt}^{xk} + 2 * v_{diag}^{xk} \qquad v_{neu}^{yk} = v_{alt}^{yk} + 2 * v_{diag}^{yk} \qquad v_{neu}^{zk} = max\{v_{alt}^{zk}, v_{diag}^{zk}\}$$

gespeichert. Dabei ist die Neigung des Gefälleelementes 6 in dem dreidimensionalen Vektor $v_{diag}$ 19 gespeichert.

Die Figur 11 stellt in der linken Darstellung eine Draufsicht einer weiteren möglichen Ausgangssituation 4, vor der Durchführung des erfindungsgemäßen Verfahrens dar. In dieser Ausgangssituation 4 grenzt an ein unbelegtes Flächenelement 7 in x-Richtung jeweils ein Gefälleelemente 6. In einem Zwischenschritt 15 wird für das unbelegte Flächenelement 7 zunächst eine Gefälleneigung festgelegt. In einem nächsten Zwischenschritt 15 grenzt das Gefälleelement 6 direkt an ein weiteres Gefälleelement 6 an, wobei die beiden Gefälleelemente 6 eine unterschiedliche Höhe haben, sodass am Übergang eine Stufe entstehen würde, an der sich Wasser stauen würde. Daher wird eine Angleichung der Höhen vorgenommen, indem die größere der beiden Höhen als Ausgangshöhe für eine Flachneigung angenommen wird. Anhand der rechten Darstellung Figur 11 ist der Endzustand 5 in einer Draufsicht ersichtlich. Das Flachelement 18 grenzt in positiver und negativer x-Richtung jeweils an ein Gefälleelement 6, somit kann Wasser in beide Richtungen von dem Flachelement 18 in Richtung der Gefälleelemente abfließen.

Die Figur 12 stellt in der linken Darstellung eine Draufsicht einer weiteren möglichen Ausgangssituation 4, vor der Durchführung des erfindungsgemäßen Verfahrens dar. In dieser Ausgangssituation 4 grenzen in y-Richtung unbelegte Flächenelemente 7 an Kehlelemente, welche in x-Richtung direkt aneinander angrenzen, wobei die Kehlneigung voneinander weg ausgerichtet ist. Anhand der rechten Darstellung der Figur 12, welche der Endzustand 5 zeigt, ist ersichtlich, dass mittels des erfindungsgemäßen Verfahrens für Flächenelemente die in y-Richtung jeweils direkt an Flächenelemente mit einer Kehlneigung angrenzen, wobei die Kehlneigung voneinander weg ausgerichtet ist eine Gefälleneigung festgelegt wird, wobei die Neigung in Richtung der Kehlelemente 8 monoton fallend ist. Somit ist eine sichere Entwässerung über die Gefälleelemente 6 möglich.

Die Figur 13 stellt in der linken Darstellung eine Draufsicht einer weiteren möglichen Ausgangssituation 4, vor der Durchführung des erfindungsgemäßen Verfahrens dar. In dieser Ausgangssituation 4 grenzt ein unbelegtes Flächenelement 7 in positiver und negativer x-Richtung jeweils an ein Kehlelement 8. In y-Richtung grenzen an die Kehlelemente 8 und an das unbelegte Flächenelement 7 jeweils unbelegte Flächenelemente 7. In einem ersten Zwischenschritt 15 wird für die in x-und y-Richtung an das erste Kehlelement angrenzenden unbelegten Flächenelemente 7 eine Gefälleneigung festgelegt. Für das in diagonaler Richtung an das erste Kehlelement angrenzende unbelegte Flächenelement wird eine Kehlneigung festgelegt. In einem zweiten Zwischenschritt 15 würden für an das zweite Kehlelement in x-und y-Richtung angrenzenden Flächenelemente theoretisch auch Gefälleneigungen festgelegt, die jedoch in genau entgegengesetzter Richtung geneigt wären, wie die im ersten Zwischenschritt festgelegten Neigungen für das Gefälleelement. Für das in diagonaler Richtung angrenzende Flächenelement würde gleichermaßen eine Kehlneigung festgelegt, die ebenfalls in genau entgegengesetzter Richtung geneigt wäre, wie die im ersten Zwischenschritt 15 festgelegte Kehlneigung. Da so eine Entwässerung nicht ermöglicht wird und es zu einer Stauung des Wassers kommen kann, erfolgt eine automatische Anpassung der Neigung und entsprechende Neufestlegung. Die somit erreichte Endzustand 5 zeigt die rechte Darstellung der Figur 13. Daraus ist ersichtlich, dass für das in x-Richtung zwischen den beiden Kehlelementen 8 liegenden Flächenelement eine Flachneigung festgelegt wird. Die Höhe des Flachelementes 18 entspricht der Höhe des Kehlelementes 8 mit der größeren Höhe, sodass Wasser vom Flachelement 18 in alle Richtungen abfließen kann. Die in y-Richtung angrenzenden Gefälleelemente 6 entwässern aufgrund ihrer Neigung in Richtung der Kehlelemente 8.

Die Figur 14 stellt in der linken Darstellung eine Draufsicht einer weiteren möglichen Ausgangssituation 4, vor der Durchführung des erfindungsgemäßen Verfahrens dar. In dieser Ausgangssituation 4 grenzt in x-und/oder y-Richtung jeweils ein unbelegtes Flächenelement 7 an ein Kehlelement 8. Die beiden Kehlelemente 8 grenzen in diagonaler Richtung aneinander, wobei beiden Kehlelemente 8 voneinander weg geneigt sind. Um eine sichere Entwässerung eines jeden Punktes sicherzustellen, wird für die in x-und/oder y-Richtung angrenzenden unbelegte Flächenelemente 7 eine Gratneigung festgelegt. Anhand der rechten Darstellung der Figur 14 wird der Endzustand 5 ersichtlich, in der die Gratelemente 17 monoton fallend in Richtung der Kehlelemente 8 sind.

Die Figur 15 stellt in der linken Darstellung eine Draufsicht einer weiteren möglichen Ausgangssituation 4, vor der Durchführung des erfindungsgemäßen Verfahrens dar. In dieser Ausgangssituation 4 grenzt ein unbelegtes Flächenelement 7 in x-und/oder y-Richtung und in diagonaler Richtung direkt an drei Kehlelemente 8. Aus der rechten Darstellung der Figur 15 ist ersichtlich, dass in einem

Verfahrensschritt eine Gratneigung festgelegt wird. Das Gratelement 17 ist monoton fallend in Richtung der Kehlelemente 8 geneigt, sodass auch in diesem Endzustand eine Entwässerung gewährleistet ist.

Die Figur 16 stellt in der linken Darstellung eine Draufsicht einer weiteren möglichen Ausgangssituation 4, vor der Durchführung des erfindungsgemäßen Verfahrens dar. In dieser Ausgangssituation 4 grenzt ein Kehlelement 8 in diagonaler und in x-und/oder y-Richtung direkt an drei unbelegte Flächenelemente 7, wobei zwischen den einzelnen Flächenelementen ein Kollisionspunkt 16 liegt, der beispielsweise ein Dachrand oder ein Lichtschacht ist. In einem ersten Zwischenschritt 15 wird für die in x- und y-Richtung angrenzenden Flächenelemente eine Gefälleneigung und für das in diagonaler Richtung angrenzende Flächenelement eine Kehlneigung festgelegt. Aus der mittleren Darstellung der Figur 16 ist ersichtlich, dass das in diagonaler Richtung an den Kollisionspunkt 16 angrenzende Kehlelement 8 in Richtung des Kollisionspunktes 16 entwässern würde, es würde somit zu einer Stauung des Wassers am Kollisionspunkt 16 kommen, falls der Kollisionspunkt 16 beispielsweise als Fahrstuhlschacht 16 ausgebildet ist. Sollte der Kollisionspunkt

16 als Dachrand ausgebildet sein und das Kehlelement 8 in diese Richtung entwässern, würde das Wasser möglicherweise über den Dachrand 16 ablaufen und an die Fassade gelangen, was zu Verunreinigungen führt. Wasser soll stets um den Kollisionspunkt herumgeleitet werden.

In diesem Fall wird daher für das in diagonaler Richtung an das Kehlelement 8, welches an den Kollisionspunkt 8 angrenzt, angrenzende Flächenelement eine Gefälleneigung festgelegt, die in paralleler Richtung zum Kollisionspunkt 16 geneigt ist. Die rechte Darstellung der Figur 16 zeigt der Endzustand 5 in der das Gefälleelement 6 entlang des Dachrandes 16 entwässert.

In der ersten Darstellung der Figur 17 ist ein Grundriss 20 einer Fläche mit drei Entwässerungspunkten 21 ersichtlich. Wie in der zweiten Darstellung der Figur 17 erkennbar, werden ausgehenden von den Entwässerungspunkten 21 für die vier direkt angrenzenden unbelegten Flächenelemente 7 jeweils Kehlneigungen festgelegt, die in Richtung des jeweiligen Entwässerungspunktes monoton fallend sind, sodass auf die Fläche auftreffendes Wasser in Richtung des Entwässerungspunktes fließt. In der dritten Darstellung der Figur 17 ist ersichtlich, dass ausgehend von an den Entwässerungspunkt 21 angrenzenden Kehlelementen 8 sukzessive für jedes weitere in x- und y- und diagonaler Richtung angrenzende unbelegte Flächenelement 7 eine Neigung in Abhängigkeit der Neigung der angrenzenden Flächenelemente festgelegt wird. Entsprechend der jeweiligen Ausgangssituation wird gemäß den eingangs beschriebenen Verfahrensschritten eine Neigung für jedes unbelegte Flächenelement 7 festgelegt. Die Neigung eines Flächenelementes wird dabei stets so festgelegt, dass eine Entwässerung von jedem Punkt der Fläche 1 in einen Entwässerungspunkt 21 erfolgt. Dazu muss jede Neigung so festgelegt werden, dass Wasser um jeden Kollisionspunkt 16 herumgeleitet wird und es an keinem Punkt der Fläche 1 zu einer Stauung kommt.

In der fünften Darstellung der Figur 17 ist für alle Flächenelemente innerhalb des Grundrisses 20 eine Neigung festgelegt, jedes der Flächenelemente ist mit einem dreidimensionalen Vektor belegt, in dem die Neigung in Betrag und Richtung hinterlegt ist. Somit ist das Ende des Verfahrens erreicht.

BEZUGSZEICHENLISTE

| | |
|---|---|
| 1 | Fläche |
| 2 | Flächenelement |
| 3 | Ebene |
| 3a | Vertiefung |
| 3b | Erhöhung |
| 4 | Ausgangssituation |
| 5 | Endzustand |
| 6 | Gefälleelement |
| 7 | Unbelegtes Flächenelement |
| 8 | Kehlelement |
| 9 | dreidimensionaler Vektor $v_{alt}$ |
| 10 | dreidimensionaler Vektor $v_{neu}$ |
| 11 | dreidimensionaler Vektor $v_{dx}$ |
| 12 | dreidimensionaler Vektor $v_{dy}$ |
| 13 | Länge des Flächenelementes $g_h$ |
| 14 | Breite des Flächenelementes $g_b$ |
| 15 | Zwischenschritt |
| 16 | Kollisionspunkt |
| 17 | Gratelement |
| 18 | Flachelement |
| 19 | dreidimensionaler Vektor $v_{diag}$ |
| 20 | Grundriss |
| 21 | Entwässerungspunkt |

## Patentansprüche

1. Verfahren zur Erstellung einer Struktur einer Topologie einer definiert begrenzten Fläche (1) zu deren Entwässerung über wenigstens einen vorgegebenen Entwässerungspunkt (21), sodass die Fläche (1) ausgehend von dem Entwässerungspunkt (21) bis zu einem Kollisionspunkt (16) eine monoton steigende Neigung aufweist, wobei die Topologie durch computerimplementierte Verfahrensschritte festgelegt wird, indem die Fläche (1) in einzelne Flächenelemente (2) mit jeweils wenigstens einer Ebene (3) unterteilt wird, und

für jedes Flächenelement (2) ausgehend von dem Entwässerungspunkt (21) sukzessive in jeder Ebene (3) eine Neigung in eine erste und/oder eine zur ersten Richtung senkrecht ausgerichteten zweiten Richtung festgelegt wird, um die Fläche (1) ausgehend von dem Entwässerungspunkt (21) bis zu dem Kollisionspunkt (16) mit der monoton steigenden Neigung zu bilden, wobei für mindestens ein direkt an den Entwässerungspunkt (21) angrenzendes Flächenelement (2) eine Kehlneigung (8) festgelegt wird, indem das betreffende Flächenelement (2) in mindestens zwei Ebenen (3) unterteilt wird und sich die zugehörigen Flächennormalen kreuzen,
wobei die computerimplementierten Verfahrensschritte ausgeführt werden, um für die Fläche (1) einen Belegungsplan zur Darstellung der einzelnen Flächenelemente (2) mit den festgelegten Neigungen zu erzeugen, wobei der Belegungsplan auf einem Datenträger gespeichert wird,
wobei der Belegungsplan als eine Anleitung zur Erstellung der Struktur der Topologie entsprechend den festgelegten Neigungen erzeugt wird, wobei der Belegungsplan für die einzelnen Flächenelemente (2) jeweils wenigstens eine Abmessung und eine geometrische Form umfasst, und
wobei die Struktur der Topologie gemäß dem Belegungsplan erstellt wird, indem die Fläche (1) durch mehrere Platten belegt wird, deren Abmessung und geometrische Form entsprechend den einzelnen Flächenelementen (2) des Belegungsplans angepasst sind.

**2.** Verfahren nach Anspruch 1,

wobei die computerimplementierten Verfahrensschritte umfassen, dass die Kehlneigung (8) für jedes direkt an den Entwässerungspunkt (21) angrenzende Flächenelement (2) festgelegt wird, indem die betreffenden Flächenelemente (2) jeweils in zwei Ebenen (3) unterteilt werden und sich die zugehörigen Flächennormalen kreuzen, und/oder
wobei die mindestens zwei, vorzugsweise zwei, Ebenen (3) eines Flächenelementes mit einer Kehlneigung (8) eine Vertiefung (3a) in diagonaler Richtung entlang des Flächenelementes (8) ausbilden, und/oder
wobei die Neigung der mindestens zwei, vorzugsweise zwei, Ebenen (3) eines Flächenelementes in Abhängigkeit der Neigung der mindestens zwei, vorzugsweise zwei, Ebenen (3) der in diagonaler und/oder in einer ersten und/oder einer zur ersten Richtung senkrecht ausgerichteten zweiten Richtung angrenzenden Flächenelemente (2) in Betrag und/oder Richtung festgelegt wird.

**3.** Verfahren nach einem der vorhergehenden Ansprüche,

wobei die computerimplementierten Verfahrensschritte umfassen, dass für ein Flächenelement (2), welches in diagonaler Richtung direkt an ein Flächenelement (2) mit Kehlneigung (8) angrenzt, eine Kehlneigung (8) festgelegt wird
und/oder wobei für ein Flächenelement (2), welches in einer ersten und/oder einer zur ersten Richtung senkrecht ausgerichteten zweiten Richtung an ein Flächenelement mit einer Kehlneigung (8) angrenzt, eine Gefälleneigung (6) festgelegt wird, indem eine Neigung einer Ebene (3) des Flächenelementes (6) in eine erste und/oder eine zur ersten Richtung senkrecht ausgerichteten zweiten Richtung monoton steigend und/oder fallend festgelegt wird,
und/oder wobei für ein Flächenelement, welches in einer ersten und/oder einer zur ersten Richtung senkrecht ausgerichteten zweiten Richtung an ein Flächenelement mit einer Gefälleneigung (6) angrenzt, eine Gefälleneigung (6) festgelegt wird,
und/oder wobei die Neigung eines Flächenelementes, welches in einer ersten und/oder einer zur ersten Richtung senkrecht ausgerichteten zweiten Richtung an ein Flächenelement mit einer Gefälleneigung (6) angrenzt, wobei das Flächenelement mit der Gefälleneigung (6) in einer ersten und/oder einer zur ersten Richtung senkrecht ausgerichteten zweiten Richtung wenigstens einen Kollisionspunkt (16) aufweist, als eine Kehlneigung (8) festgelegt wird.

**4.** Verfahren nach einem der vorhergehenden Ansprüche,

wobei die computerimplementierten Verfahrensschritte umfassen, dass die Neigung einer Ebene eines Flächenelementes mit einer Gefälleneigung (6) in Richtung wenigstens eines Kollisionspunktes (16) als eine um 90° gegen den Kollisionspunkt (16) versetzte Gefälleneigung (6) festgelegt wird,
und/oder wobei für eine Ebene eines Flächenelementes, welches in einer ersten und/oder einer zur ersten Richtung senkrecht ausgerichteten zweiten Richtung jeweils an ein Flächenelement mit einer Gefälleneigung (6) angrenzt, wobei die Gefälleneigungen jeweils aufeinander zu gerichtet sind, eine Flachneigung (18) festgelegt wird, wobei die Neigung der Ebene (3) null ist, wobei der Betrag der Neigung gleich dem Betrag der Gefälleneigung (6) des angrenzenden Flächenelementes mit dem größeren Betrag ist.

**5.** Verfahren nach einem der vorhergehenden Ansprüche,
wobei die computerimplementierten Verfahrensschritte umfassen, dass für ein Flächenelement, welches in einer ersten und/oder einer zur ersten Richtung senkrecht ausgerichteten zweiten Richtung an ein Flächenelement mit einer Kehlneigung (8) angrenzt und das in diagonaler Richtung an ein Flächenelement mit einer Gefälleneigung (6) angrenzt, eine Gratneigung (17) festgelegt wird, wobei die mindestens zwei, vorzugsweise zwei, Ebenen (3) des Flächenelementes sich schneiden und/oder in einer ersten und/oder einer zur ersten Richtung senkrecht ausgerichteten zweiten Richtung in entgegengesetzter Richtung der Neigung der Flächennormalen des Flächenelementes mit der Kehlneigung (8) geneigt sind.

**6.** Verfahren nach einem der vorhergehenden Ansprüche,

wobei die computerimplementierten Verfahrensschritte umfassen, dass festgelegt wird, dass die mindestens zwei, vorzugsweise zwei, Ebenen (3) eines Flächenelementes mit einer Gratneigung (17) eine Erhöhung (3b) in diagonaler Richtung entlang des Flächenelementes ausbilden
und/oder wobei für ein Flächenelement, in dem zwei Gefälleneigungen (6) in unterschiedliche Richtung senkrecht aufeinander stehen, eine Gratneigung (17) festgelegt wird.

**7.** Verfahren nach einem der vorhergehenden Ansprüche,
wobei die computerimplementierten Verfahrensschritte umfassen, dass für ein Flächenelement, welches in einer ersten und/oder einer zur ersten Richtung senkrecht ausgerichteten zweiten Richtung und/oder in einer diagonalen Richtung direkt an wenigstens zwei, vorzugsweise zwei in einer ersten und/oder einer zur ersten Richtung senkrecht ausgerichteten zweiten Richtung direkt aneinander angrenzende Flächenelemente mit einer Kehlneigung (8) angrenzt, wobei die Kehlneigung (8) jeweils monoton steigend in Richtung eines Punktes ist, eine Gefälleneigung (6) festgelegt wird, wobei die Flächennormale des Flächenelementes (6) parallel zu den Flächennormalen des Flächenelementes mit der Kehlneigung (8) ist.

**8.** Verfahren nach einem der vorhergehenden Ansprüche,
wobei die computerimplementierten Verfahrensschritte umfassen, dass für ein Flächenelement, welches in der ersten und/oder der zur ersten Richtung senkrecht ausgerichteten zweiten Richtung zwischen zwei Flächenelementen mit jeweils einer Kehlneigung liegt, wobei die Kehlneigung (8) jeweils monoton steigend in Richtung eines Punktes ist, eine Flachneigung (18) festgelegt wird, wobei der Betrag der Neigung als der Betrag der Neigung des angrenzenden Flächenelementes mit dem größeren Betrag festgelegt wird.

**9.** Verfahren nach einem der vorhergehenden Ansprüche,
wobei die computerimplementierten Verfahrensschritte umfassen, dass für ein Flächenelement, welches in diagonaler Richtung an ein Flächenelement mit einer Kehlneigung (8) und/oder in einer ersten und/oder einer zur ersten Richtung senkrecht ausgerichteten zweiten Richtung an ein Flächenelement mit einer Flachneigung (18) angrenzt, eine Gefälleneigung (6) festgelegt wird, wobei die Flächennormale des Flächenelementes in die gleiche Richtung wie Flächennormalen der Flächenelemente mit der Kehlneigung (8) geneigt ist.

**10.** Verfahren nach einem der vorhergehenden Ansprüche,
wobei die computerimplementierten Verfahrensschritte umfassen, dass für ein Flächenelement, welches in einer ersten und/oder einer zur ersten Richtung senkrecht ausgerichteten zweiten Richtung an jeweils ein Flächenelement mit einer Kehlneigung (8) angrenzt, wobei die mindestens zwei, vorzugsweise zwei, Ebenen des Flächenelementes sich schneiden, jeweils eine Gratneigung (17) festgelegt wird.

**11.** Verfahren nach einem der vorhergehenden Ansprüche,
wobei die computerimplementierten Verfahrensschritte umfassen, dass für ein Flächenelement, welches in einer ersten und/oder einer zur ersten Richtung senkrecht ausgerichteten zweiten Richtung direkt an wenigstens drei, vorzugsweise drei Flächenelemente mit einer Kehlneigung (8) angrenzt, wobei sich die Flächennormalen der Flächenelemente mit der Kehlneigung (8) kreuzen, eine Gratneigung (17) festgelegt wird, wobei die Flächennormale des Flächenelementes mit der Gratneigung (17) nicht die Flächennormalen der Flächenelemente mit Kehlneigung (8) kreuzt.

**12.** Verfahren nach einem der vorhergehenden Ansprüche,

wobei die computerimplementierten Verfahrensschritte umfassen, dass für ein Flächenelement, welches in einer diagonalen Richtung an ein Flächenelement mit einer Kehlneigung (8) angrenzt, wobei das Flächenelement mit der Kehlneigung (8) in einer ersten und/oder einer zur ersten Richtung senkrecht ausgerichteten zweiten Richtung wenigstens einen Kollisionspunkt (16) aufweist, eine Gefälleneigung (6) festgelegt wird, wobei die Kehlneigung (8) monoton steigend in Richtung des Kollisionspunktes (16) und die Gefälleneigung (6) monoton steigend oder fallend entlang des Kollisionspunktes (16) ist, und/oder wobei die Fläche (1) eine Dachfläche ist.

**13.** Verfahren nach einem der vorhergehenden Ansprüche,
wobei die Fläche (1) eine Dachfläche oder Parkdeckfläche ist.

**14.** Verfahren nach einem der vorhergehenden Ansprüche, wobei eine Software durch einen Computer ausgeführt wird, deren Befehle den Computer veranlassen, die computerimplementierten Verfahrensschritte auszuführen, wobei wenigstens ein Entwässerungspunkt (21) und/oder ein Grundriss (20) als Eingabewert festgelegt ist.

## Claims

**1.** Method for creating a structure of a topology of a defined bounded surface (1) for dewatering said surface (1) by means of at least one predetermined drainage point (21), so that the surface (1) comprises a monotonically increasing inclination starting from the drainage point (21) up to a collision point (16),

wherein the topology is determined by computer-implemented method steps by dividing the surface (1) into individual surface elements (2) each having at least one plane (3), and
for each surface element (2), starting from the drainage point (21), an inclination in a first direction and/or a second direction perpendicular to the first direction is successively determined in each plane (3) in order to form the surface (1) starting from the drainage point (21) up to the collision point (16) with the monotonically increasing inclination, wherein for at least one surface element (2) directly adjacent to the drainage point (21) a fillet slope (8) is determined by dividing the respective surface element (2) into at least two planes (3) and crossing the associated surface normals, wherein the computer-implemented method steps are carried out to generate, for the surface (1), an allocation plan for representing the individual surface elements (2) with the specified inclinations, wherein the allocation plan is stored on a data carrier,
wherein the layout plan is generated as a guide for creating the structure of the topology according to the specified inclinations, wherein the layout plan for the individual surface elements (2) comprises at least one dimension and one geometric shape, respectively, and
wherein the structure of the topology is created according to the occupancy plan by occupying the area (1) by a plurality of panels whose dimension and geometric shape are adapted according to the individual area elements (2) of the occupancy plan.

**2.** Method according to claim 1,

wherein the computer-implemented method steps comprise that the fillet slope (8) is determined for each surface element (2) directly adjacent to the drainage point (21) by dividing the respective surface elements (2) into two planes (3) each and crossing the associated surface normals, and/or wherein the at least two, preferably two, planes (3) of a surface element with a fillet slope (8) form a depression (3a) in diagonal direction along the surface element (8),
and/or
wherein the inclination of the at least two, preferably two, planes (3) of a surface element is determined in dependence on the inclination of the at least two, preferably two, planes (3) of the surface elements (2) adjoining in diagonal and/or in a first direction and/or in a second direction aligned perpendicular to the first direction in amount and/or direction.

**3.** Method according to any one of the preceding claims,

wherein the computer-implemented method steps comprise that for a surface element (2) which directly adjoins a surface element (2) with a fillet slope (8) in a diagonal direction, a fillet slope (8) is determined and/or wherein a slope inclination (6) is determined for a surface element (2) which adjoins a surface element with a fillet inclination (8) in a first direction and/or in a second direction perpendicular to the first direction, in that an inclination of a plane (3) of the surface element (6) in a first direction and/or in a second direction perpendicular

to the first direction is determined to be monotonically increasing and/or decreasing,
and/or wherein a slope (6) is determined for a surface element which adjoins a surface element with a slope (6) in a first direction and/or in a second direction perpendicular to the first direction,
and/or wherein the inclination of a surface element which adjoins a surface element with a slope (6) in a first direction and/or in a second direction perpendicular to the first direction, wherein the surface element with the slope (6) has at least one collision point (16) in a first direction and/or in a second direction perpendicular to the first direction, is defined as a fillet inclination (8).

**4.** Method according to any one of the preceding claims,

wherein the computer-implemented method steps comprise that the inclination of a plane of a surface element with a slope inclination (6) in the direction of at least one collision point (16) is determined as a slope inclination (6) offset by 90° with respect to the collision point (16),
and/or wherein a flat slope (18) is defined for a plane of a surface element which, in a first direction and/or in a second direction aligned perpendicularly to the first direction, in each case adjoins a surface element with a slope inclination (6), the slope inclinations in each case being directed towards one another, the slope of the plane (3) being zero, the amount of the slope being equal to the amount of the slope inclination (6) of the adjoining surface element with the greater amount.

**5.** Method according to any one of the preceding claims,
wherein the computer-implemented method steps comprise that for a surface element which in a first direction and/or in a second direction perpendicular to the first direction adjoins a surface element with a fillet slope (8) and which in a diagonal direction adjoins a surface element with a slope slope (6) a ridge inclination (17) is defined, wherein the at least two, preferably two, planes (3) of the surface element intersect and/or are inclined in a first direction and/or in a second direction aligned perpendicular to the first direction in the opposite direction of the inclination of the surface normal of the surface element with the ridge inclination (8).

**6.** Method according to any of the preceding claims,

wherein the computer-implemented method steps comprise determining that the at least two, preferably two, planes (3) of a surface element with a ridge slope (17) form an elevation (3b) in diagonal direction along the surface element
and/or wherein a ridge inclination (17) is determined for a surface element in which two slope inclinations (6) are perpendicular to each other in different directions.

**7.** Method according to any one of the preceding claims,
wherein the computer-implemented method steps comprise that, for a surface element which is directly adjacent in a first direction and/or in a second direction perpendicular to the first direction and/or in a diagonal direction to at least two, preferably two surface elements directly adjoining one another in a first direction and/or in a second direction perpendicular to the first direction and having a throat slope (8), the fillet slope (8) in each case being monotonically increasing in the direction of a point, a slope (6) is determined, the surface normal of the surface element (6) being parallel to the surface normals of the surface element having the throat slope (8).

**8.** Method according to any one of the preceding claims,
wherein the computer-implemented method steps comprise determining a flat slope (18) for a surface element which lies in the first direction and/or the second direction perpendicular to the first direction between two surface elements each having a fillet slope, the fillet slope (8) being in each case monotonically increasing in the direction of a point, the amount of the slope being determined as the amount of the slope of the adjacent surface element having the larger amount.

**9.** Method according to any one of the preceding claims,
wherein the computer-implemented method steps comprise determining a slope inclination (6) for a surface element which is adjacent in a diagonal direction to a surface element with a fillet inclination (8) and/or in a first direction and/or in a second direction aligned perpendicular to the first direction to a surface element with a flat inclination (18), wherein the surface normal of the surface element is inclined in the same direction as surface normals of the surface elements with the fillet inclination (8).

**10.** Method according to any one of the preceding claims,

wherein the computer-implemented method steps comprise that for a surface element, which in a first direction and/or a second direction aligned perpendicularly to the first direction adjoins in each case a surface element with a fillet slope (8), wherein the at least two, preferably two, planes of the surface element intersect, in each case a fillet slope (17) is determined.

**11.** Method according to one of the preceding claims,
wherein the computer-implemented method steps comprise that for a surface element which in a first direction and/or a second direction perpendicular to the first direction directly adjoins at least three, preferably three, surface elements with a fillet slope (8) wherein the surface normals of the surface elements with the fillet slope (8) cross, a ridge slope (17) is determined, wherein the surface normal of the surface element with the ridge slope (17) does not cross the surface normals of the surface elements with fillet slope (8).

**12.** A method according to any one of the preceding claims,
wherein the computer-implemented method steps comprise that for a surface element which in a diagonal direction adjoins a surface element with a fillet slope (8), wherein the surface element with the fillet slope (8) has at least one collision point (16) in a first direction and/or in a second direction perpendicular to the first direction, a slope inclination (6) is determined, wherein the fillet inclination (8) is monotonically increasing in the direction of the collision point (16) and the slope inclination (6) is monotonically increasing or decreasing along the collision point (16), and/or wherein the surface (1) is a roof surface.

**13.** Method according to any one of the preceding claims,
wherein the surface (1) is a roof surface or parking deck surface .

**14.** Method according to any one of the preceding claims, wherein software is executed by a computer, the instructions of which cause the computer to execute the computer-implemented method steps, wherein at least one drainage point (21) and/or floor plan (20) is determined as an input value.

## Revendications

**1.** Procédé pour créer une structure d'une topologie d'une surface (1) définie limitée pour son drainage par au moins un point de drainage (21) donné, de sorte que la surface (1) présente une inclinaison monotone croissante à partir du point de drainage (21) jusqu'à un point de collision (16),
dans lequel

on définit la topologie par des étapes de procédé mises en oeuvre par ordinateur, en divisant la surface (1) en éléments de surface (2) individuels ayant chacun au moins un plan (3), et en définissant, pour chaque élément de surface (2), à partir du point de drainage (21), successivement dans chaque plan (3), une inclinaison dans une première direction et/ou dans une deuxième direction orientée perpendiculairement à la première direction, afin de former la surface (1) avec l'inclinaison monotone croissante à partir du point de drainage (21) jusqu'au point de collision (16),
on définit une inclinaison de noue (8) pour au moins un élément de surface (2) directement adjacent au point de drainage (21), en divisant l'élément de surface (2) concerné en au moins deux plans (3), les droites normales à la surface associées se croisant,
on exécute les étapes de procédé mises en oeuvre par ordinateur afin de générer un schéma de couverture pour la surface (1), destiné à représenter les éléments de surface (2) individuels avec les inclinaisons définies, le schéma de couverture étant stocké sur un support de données,
on génère le schéma de couverture comme un guide pour la création de la structure de la topologie selon les inclinaisons définies, le schéma de couverture comprenant au moins une dimension et une forme géométrique pour chacun des éléments de surface (2) individuels, et
on crée la structure de la topologie conformément au schéma de couverture, en couvrant la surface (1) de plusieurs panneaux dont la dimension et la forme géométrique sont adaptées en fonction des éléments de surface (2) individuels du schéma de couverture.

**2.** Procédé selon la revendication 1,

dans lequel les étapes de procédé mises en oeuvre par ordinateur consistent à
définir l'inclinaison de noue (8) pour chaque élément de surface (2) directement adjacent au point de drainage

(21), en divisant chacun des éléments de surface (2) concernés en deux plans (3), les droites normales à la surface associées se croisant, et/ou
lesdits au moins deux, de préférence deux, plans (3) d'un élément de surface avec une inclinaison de noue (8) formant un renfoncement (3a) le long de l'élément de surface (8) dans la direction diagonale,
et/ou
définir, en valeur absolue et/ou en direction, l'inclinaison desdits au moins deux, de préférence deux, plans (3) d'un élément de surface en fonction de l'inclinaison desdits au moins deux, de préférence deux, plans (3) des éléments de surface (2) adjacents dans la direction diagonale et/ou dans une première direction et/ou dans une deuxième direction orientée perpendiculairement à la première direction.

3. Procédé selon l'une des revendications précédentes,

dans lequel les étapes du procédé mises en oeuvre par ordinateur consistent à
définir une inclinaison de noue (8) pour un élément de surface (2) qui, dans la direction diagonale, est directement adjacent à un élément de surface (2) avec une inclinaison de noue (8),
et/ou
définir une inclinaison de pente (6) pour un élément de surface (2) qui, dans une première direction et/ou dans une deuxième direction orientée perpendiculairement à la première direction, est adjacent à un élément de surface avec une inclinaison de noue (8), en définissant une inclinaison monotone croissante et/ou décroissante d'un plan (3) de l'élément de surface (6) dans une première direction et/ou dans une deuxième direction orientée perpendiculairement à la première direction,
et/ou
définir une inclinaison de pente (6) pour un élément de surface qui, dans une première direction et/ou dans une deuxième direction orientée perpendiculairement à la première direction, est adjacent à un élément de surface avec une inclinaison de pente (6),
et/ou
définir l'inclinaison d'un élément de surface comme étant une inclinaison de noue (8), élément qui, dans une première direction et/ou dans une deuxième direction orientée perpendiculairement à la première direction, est adjacent à un élément de surface avec une inclinaison de pente (6), l'élément de surface avec l'inclinaison de pente (6) présentant au moins un point de collision (16) dans une première direction et/ou dans une deuxième direction orientée perpendiculairement à la première direction.

4. Procédé selon l'une des revendications précédentes,

dans lequel les étapes de procédé mises en oeuvre par ordinateur consistent à
définir l'inclinaison d'un plan d'un élément de surface avec une inclinaison de pente (6) dans la direction d'au moins un point de collision (16) comme étant une inclinaison de pente (6) décalée de 90° par rapport au point de collision (16),
et/ou
définir une inclinaison plate (18) pour un plan d'un élément de surface qui, dans une première direction et/ou dans une deuxième direction orientée perpendiculairement à la première direction, est adjacent à un élément de surface respectif avec une inclinaison de pente (6), les inclinaisons de pente étant chacune dirigées l'une vers l'autre, l'inclinaison du plan (3) étant nulle, la valeur absolue de l'inclinaison étant égale à la valeur absolue de l'inclinaison de pente (6) de l'élément de surface adjacent avec la plus grande valeur absolue.

5. Procédé selon l'une des revendications précédentes,

dans lequel les étapes du procédé mises en oeuvre par ordinateur consistent à
définir une inclinaison d'arêtier (17) pour un élément de surface qui, dans une première direction et/ou dans une deuxième direction orientée perpendiculairement à la première direction, est adjacent à un élément de surface avec une pente de noue (8) et qui, dans la direction diagonale, est adjacent à un élément de surface avec une inclinaison de pente (6), lesdits au moins deux, de préférence deux, plans (3) de l'élément de surface se coupant et/ou étant inclinés dans une première direction et/ou dans une deuxième direction orientée perpendiculairement à la première direction, en sens opposé à l'inclinaison de la droite normale à la surface de l'élément de surface avec la pente de noue (8).

6. Procédé selon l'une des revendications précédentes,

dans lequel les étapes du procédé mises en oeuvre par ordinateur consistent à
définir que lesdits au moins deux, de préférence deux, plans (3) d'un élément de surface avec une inclinaison d'arêtier (17) forment une élévation (3b) le long de l'élément de surface dans la direction diagonale,
et/ou
définir une pente d'arêtier (17) pour un élément de surface dans lequel deux inclinaisons de pente (6) sont perpendiculaires l'une à l'autre dans des directions différentes.

**7.** Procédé selon l'une des revendications précédentes,

dans lequel les étapes de procédé mises en oeuvre par ordinateur consistent à
définir une inclinaison de pente (6) pour un élément de surface qui, dans une première direction et/ou dans une deuxième direction orientée perpendiculairement à la première direction et/ou dans une direction diagonale, est directement adjacent à au moins deux, de préférence deux, éléments de surface avec une pente de noue (8) qui sont directement adjacents l'un à l'autre dans une première direction et/ou dans une deuxième direction orientée perpendiculairement à la première direction, la pente de noue (8) étant respectivement monotone croissante en direction d'un point, la droite normale à la surface de l'élément de surface (6) étant parallèle à la droite normale à la surface de l'élément de surface avec la pente de noue (8).

**8.** Procédé selon l'une des revendications précédentes,

dans lequel les étapes du procédé mises en oeuvre par ordinateur consistent à
définir une inclinaison plate (18) pour un élément de surface qui, dans la première direction et/ou dans la deuxième direction orientée perpendiculairement à la première direction, est situé entre deux éléments de surface ayant chacun une inclinaison de noue, l'inclinaison de noue (8) étant respectivement monotone croissante en direction d'un point, la valeur absolue de l'inclinaison étant définie comme étant la valeur absolue de l'inclinaison de l'élément de surface adjacent ayant la valeur absolue la plus grande.

**9.** Procédé selon l'une des revendications précédentes,

dans lequel les étapes du procédé mises en oeuvre par ordinateur consistent à
définir une inclinaison de pente (6) pour un élément de surface qui, dans la direction diagonale, est adjacent à un élément de surface avec une inclinaison de noue (8) et/ou qui, dans une première direction et/ou une dans deuxième direction orientée perpendiculairement à la première direction, est adjacent à un élément de surface avec une inclinaison plate (18), la droite normale à la surface de l'élément de surface étant inclinée dans la même direction que les droites normales à la surface des éléments de surface avec l'inclinaison de noue (8).

**10.** Procédé selon l'une des revendications précédentes,

dans lequel les étapes de procédé mises en oeuvre par ordinateur consistent à
définir une inclinaison d'arêtier (17) pour un élément de surface qui, dans une première direction et/ou dans une deuxième direction orientée perpendiculairement à la première direction, est adjacent à un élément de surface respectif ayant une inclinaison de noue (8), lesdits au moins deux, de préférence deux, plans de l'élément de surface se coupant.

**11.** Procédé selon l'une des revendications précédentes,

dans lequel les étapes de procédé mises en oeuvre par ordinateur consistent à
définir une inclinaison d'arêtier (17) pour un élément de surface qui, dans une première direction et/ou dans une deuxième direction orientée perpendiculairement à la première direction, est directement adjacent à au moins trois, de préférence trois, éléments de surface avec une inclinaison de noue (8), les droites normales à la surface des éléments de surface avec l'inclinaison de noue (8) se croisant, la droite normale à la surface de l'élément de surface avec l'inclinaison d'arêtier (17) ne croisant pas les droites normales à la surface des éléments de surface avec l'inclinaison de noue (8).

**12.** Procédé selon l'une des revendications précédentes,

dans lequel les étapes du procédé mises en oeuvre par ordinateur consistent à
définir une inclinaison de pente (6) pour un élément de surface qui, dans une direction diagonale, est adjacent

à un élément de surface avec une inclinaison de noue (8), l'élément de surface avec l'inclinaison de noue (8) présentant au moins un point de collision (16) dans une première direction et/ou dans une deuxième direction orientée perpendiculairement à la première direction, l'inclinaison de noue (8) étant monotone croissante en direction du point de collision (16), et l'inclinaison de pente (6) étant monotone croissante et/ou décroissante le long du point de collision (16), et/ou la surface (1) étant une surface de toit.

**13.** Procédé selon l'une des revendications précédentes,
dans lequel la surface (1) est une surface de toit ou une surface de plateforme de stationnement.

**14.** Procédé selon l'une des revendications précédentes,
dans lequel un logiciel est exécuté par un ordinateur, dont les instructions amènent l'ordinateur à exécuter les étapes du procédé mises en oeuvre par ordinateur, au moins un point de drainage (21) et/ou un plan de niveau (20) étant défini comme valeur d'entrée.

Fig.1

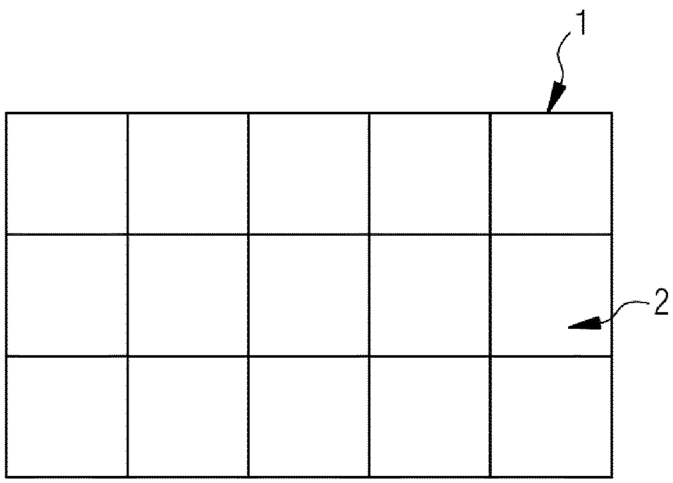

Fig.2

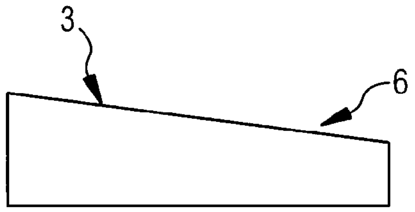


Fig.3

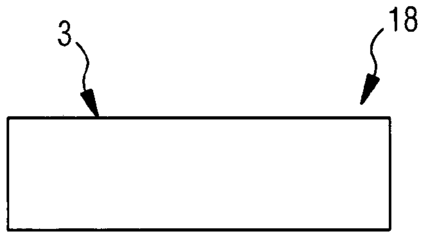


Fig.4

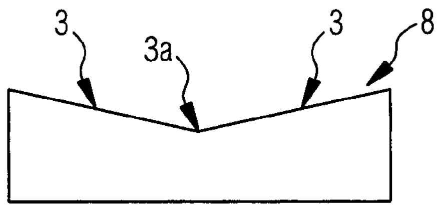


Fig.5

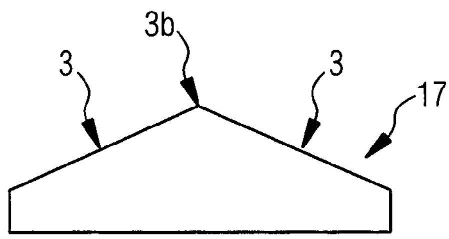

Fig.6

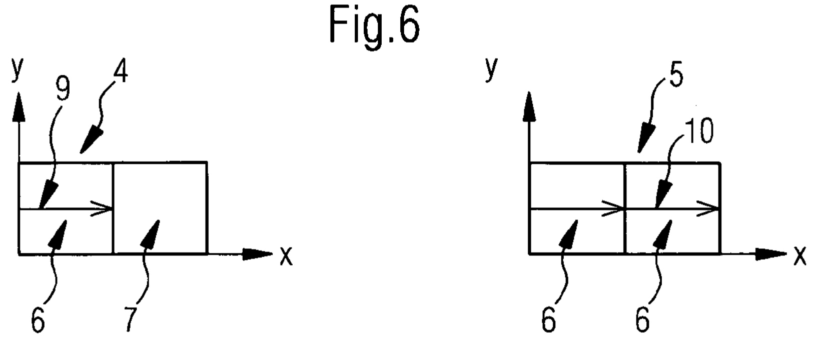


Fig.7

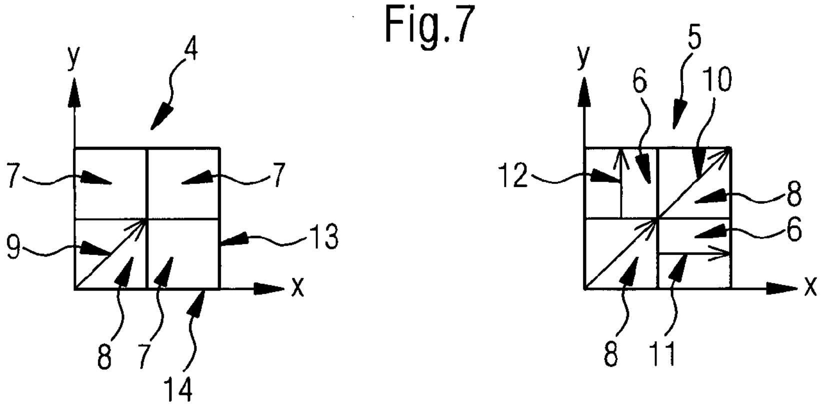


Fig.8

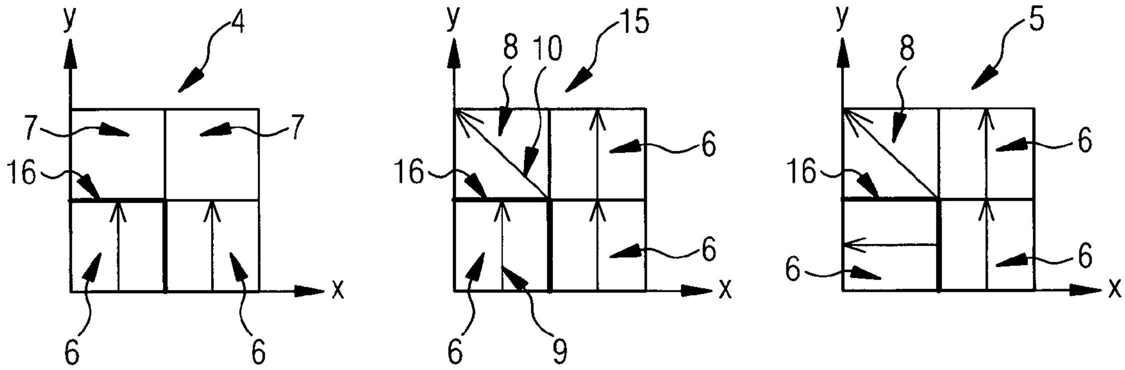


Fig.9

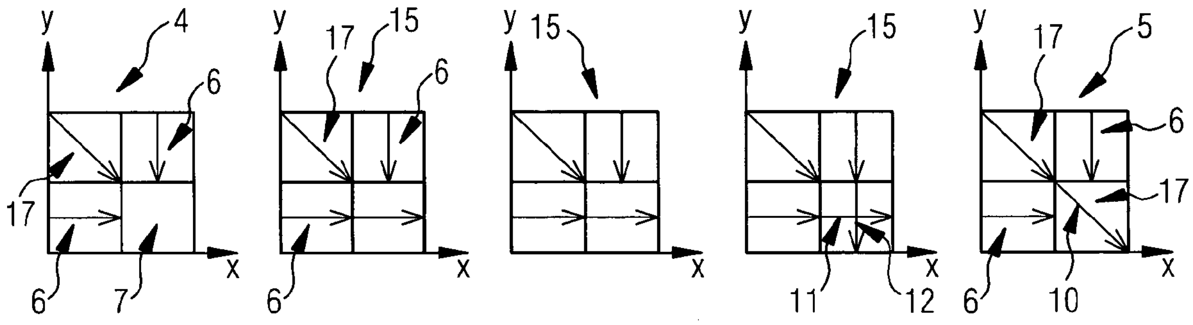

Fig.10

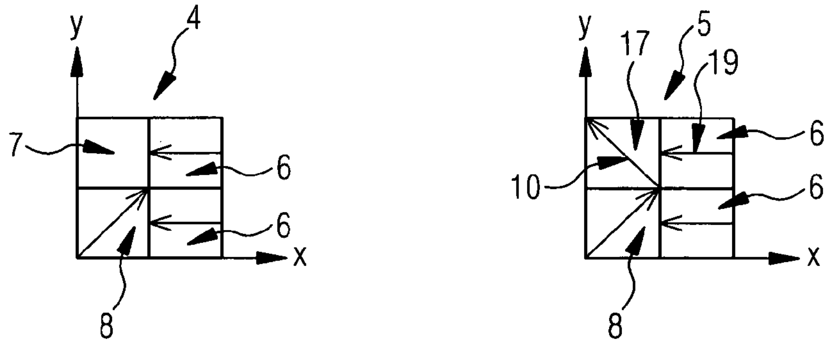


Fig.11

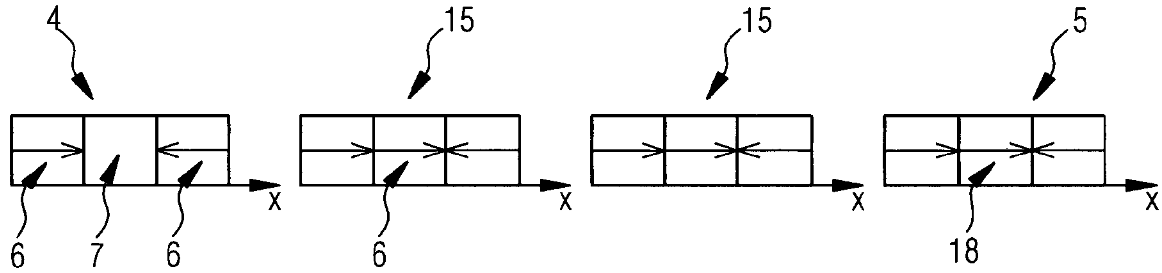


Fig.12

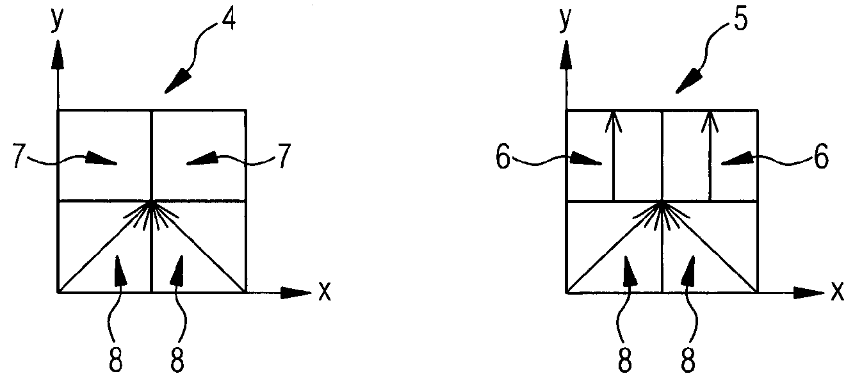

Fig.13

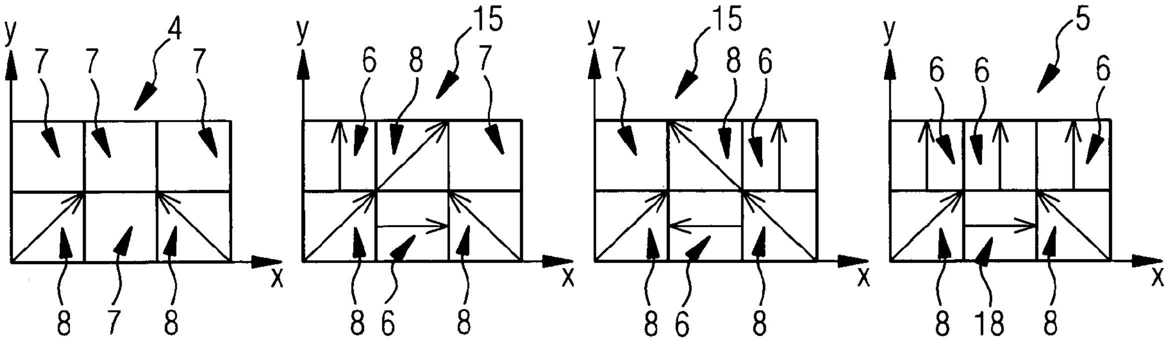


Fig.14

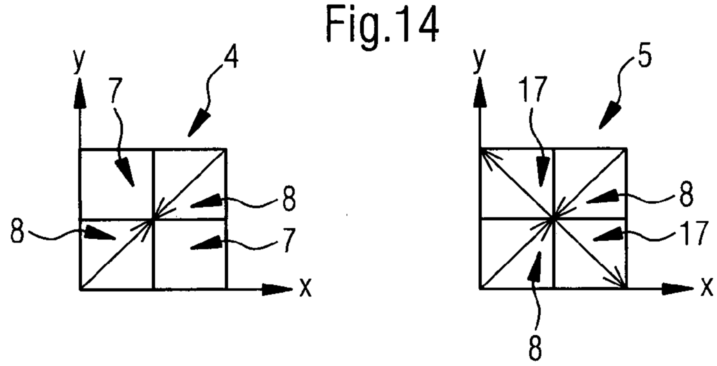


Fig.15

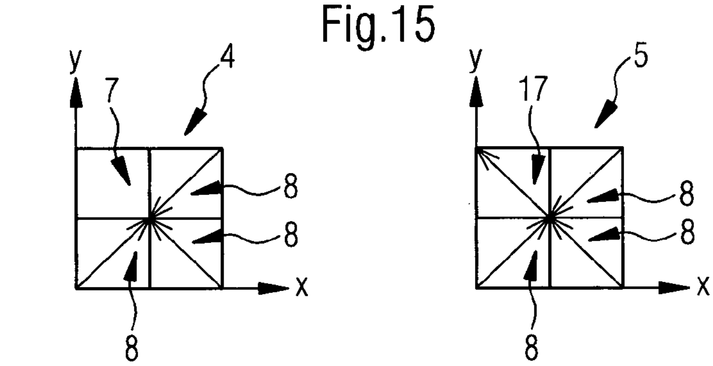


Fig.16

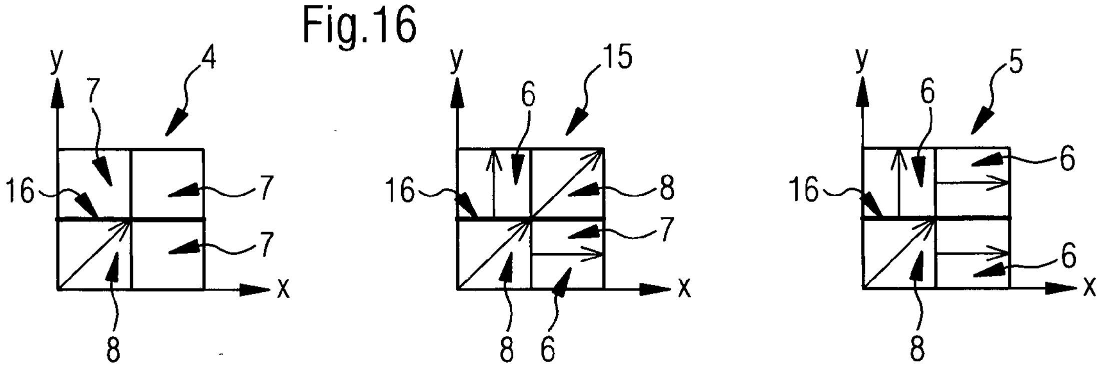

Fig.17

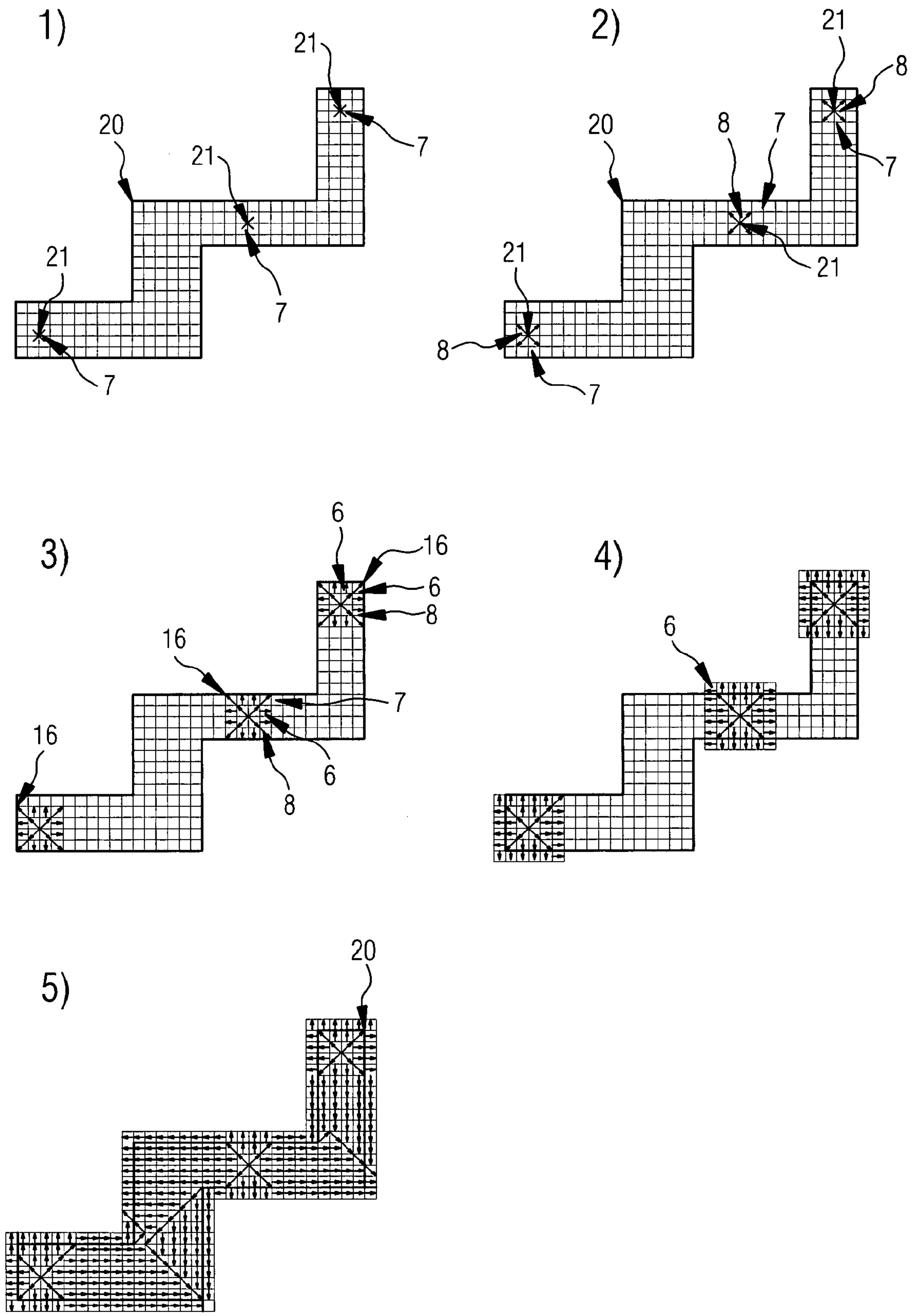

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 5663882 A
- CA 2521801 A1
- ES 2297959 A1